# EUROPEAN PATENT SPECIFICATION

(11) **EP 4 517 346 B1**
(45) Date of publication and mention of the grant of the patent: **04.11.2026**
(21) Application number: 22947607.2
(22) Date of filing: 31.08.2022
(51) Int. Cl.: H02H 3/44, H02H 1/00, G01R 31/08, G01R 19/25, H02H 7/26

(54) **FAULT IDENTIFICATION METHOD AND SYSTEM BASED ON FULL-TIME-DOMAIN ABRUPT CHANGE INFORMATION, ELECTRONIC DEVICE, AND COMPUTER-READABLE STORAGE MEDIUM**
VERFAHREN UND SYSTEM ZUR FEHLERERKENNUNG AUF DER BASIS VON INFORMATIONEN ÜBER ABRUPTEN ÄNDERUNGEN IM VOLLSTÄNDIGEN ZEITBEREICH, ELEKTRONISCHE VORRICHTUNG UND COMPUTERLESBARES SPEICHERMEDIUM
PROCÉDÉ ET SYSTÈME D'IDENTIFICATION DE DÉFAUT BASÉS SUR DES INFORMATIONS DE CHANGEMENT ABRUPT DE DOMAINE TEMPOREL COMPLET, DISPOSITIF ÉLECTRONIQUE ET SUPPORT D'ENREGISTREMENT LISIBLE PAR ORDINATEUR

(30) Priority: 23.06.2022 CN 202210717823
(43) Date of publication of application: 05.03.2025
(73) Proprietor: China Electric Power Research Institute, Beijing 100192 (CN)
(72) Inventor: WANG, Congbo, Beijing 100192 (CN); YANG, Guosheng, Beijing 100192 (CN); YU, Yue, Beijing 100192 (CN); JIANG, Shuai, Beijing 100192 (CN); CAO, Hong, Beijing 100192 (CN); DOU, Xuewei, Beijing 100192 (CN); XUE, Zhiying, Beijing 100192 (CN); WANG, Jianfeng, Beijing 100192 (CN)
(74) Representative: Mathys & Squire
(86) International application number: PCT/CN2022/116214
(87) International publication number: WO 2023/245866

(56) References cited:
- CN-A- 106 786 424
- CN-A- 114 219 947
- CN-A- 114 966 323
- US-A1- 2022 021 202
- US-B1- 10 985 558
- US-B1- 10 985 558
- ZHENG LIMING ET AL: "Singular Value Decomposition Based Pilot Protection for Transmission Lines With Converters on Both Ends", IEEE TRANSACTIONS ON POWER DELIVERY, IEEE SERVICE CENTER, NEW YORK, NY, US, vol. 37, no. 4, 23 September 2021 (2021-09-23), pages 2728 - 2737, XP011914990, ISSN: 0885-8977, [retrieved on 20210924], DOI: 10.1109/TPWRD.2021.3115117
- SHA ZHAOYI ET AL: "AC Line Pilot Protection Based on Multi-order Mutation Characteristics", 2022 4TH INTERNATIONAL CONFERENCE ON POWER AND ENERGY TECHNOLOGY (ICPET), IEEE, 28 July 2022 (2022-07-28), pages 64 - 69, XP034210998, DOI: 10.1109/ICPET55165.2022.9918200
- GEDDADA NAGESH ET AL: "Experimental Validation of Fault Identification in VSC-Based DC Grid System", IEEE TRANSACTIONS ON INDUSTRIAL ELECTRONICS, IEEE SERVICE CENTER, PISCATAWAY, NJ, USA, vol. 65, no. 6, 1 June 2018 (2018-06-01), pages 4799 - 4809, XP011677207, ISSN: 0278-0046, [retrieved on 20180214], DOI: 10.1109/TIE.2017.2767560
- ZHENG, LIMING ET AL.: "Singular Value Decomposition Based Pilot Protection for Transmission Lines With Converters on Both Ends", IEEE TRANSACTIONS ON POWER DELIVERY, vol. 37, no. 4, 24 September 2021 (2021-09-24), XP011914990, ISSN: 0885-8977, DOI: 10.1109/TPWRD.2021.3115117
- ZHENG, LIMING; JIA, KE; HOU, LAIYUN; BI, TIANSHU: "Singular Value Decomposition Based Protection for AC Transmission Lines of VSC-HVDC System With Offshore Wind Farms", PROCEEDINGS OF THE CSEE, ZHONGGUO DIANJI GONGCHENG XUEHUI, CN, vol. 40, no. Suppl. 1, 31 August 2020 (2020-08-31), CN , pages 75 - 83, XP009551827, ISSN: 0258-8013, DOI: 10.13334/j.0258-8013.pcsee.200918
- ZHENG LIMING ET AL.: "Singular Value Decomposition Based Pilot Protection for Transmission Lines With Converters on Both Ends", IEEE TRANSACTIONS ON POWER DELIVERY, vol. 37, no. 4, 24 September 2021 (2021-09-24), XP011914990, ISSN: 0885-8977, DOI: 10.1109/TPWRD.2021.3115117

## Description

### CROSS-REFERENCE TO RELATED APPLICATION

The present disclosure is based on and claims priority to Chinese Patent Application No. 202210717823.0 filed on June 23, 2022 and entitled "FAULT IDENTIFICATION METHOD AND SYSTEM BASED ON FULL-TIME-DOMAIN ABRUPT CHANGE INFORMATION",

### TECHNICAL FIELD

The present disclosure relates to the field of power system protection technology, and relates to, but is not limited to, a fault identification method and a fault identification system based on full-time-domain abrupt change information, an electronic device, and a computer-readable storage medium.

### BACKGROUND

With the increasing proportion of new energy such as wind power and photovoltaic, the scale of the power grid is continuously expanding, and security of China's new power system is facing serious challenges. High proportion of new energy has become an important characteristic of the new power system. In the new power system, since a large number of power electronic converters are incorporated into the power grid, the fault transient process is closely related to the control strategy and parameters of the power electronic device, the amplitude of the short-circuit current is limited, the phase angle of the short-circuit current is controlled, and the content of non-characteristic harmonic increases significantly, which would lead to a certain threat to the reliability and sensitivity of the conventional power frequency based relay protection, make the performance of the conventional differential protection decrease, and seriously affects the safe operation of the new energy power system. At present, according to different types of fault information, existing protection principles may be subdivided into full-time-domain information protection and frequency-domain information protection. The full-time-domain information protection represents the difference between the current transient waveforms of the new energy station and the current transient waveforms of the power grid by cosine similarity, Spearman grade correlation coefficient, Pearson correlation coefficient, or the like. However, such method completely depends on the voltage and current on both sides of the line. When the output of the new energy station is small, or when the new energy station is incorporated into the weak power grid, the overall current amplitude is small, and there is a risk of performance decrease of the protection, or even a risk of failure to actuate. As for the protection of the frequency-domain information, the conventional protection method using power frequency quantity information needs to extract the power frequency quantity information from sample values of the current and voltage after the fault, so as to form a protection criterion. However, since line fault information adopted by such method is mainly the power frequency quantity, it is easy to be affected by characteristics of the new energy station, such as the limited amplitude of the short-circuit current, the controlled phase angle, the frequency deviation, or the like, which leads to the decrease of the protection performance. Therefore, a new fault identification method is urgently needed when the high-voltage Alternating Current (AC) line fails.

Document XP011914990 entitled "Singular Value Decomposition Based Pilot Protection for Transmission Lines With Converters on Both Ends" by ZHENG LIMING ET AL proposes a novel singular value decomposition (SVD) based pilot protection. A Hankel matrix is established for the short-circuit current at each end of the AC line. The Hankel matrix rapidly detects the singularity of the signal and its derivative, and the SVD method uses a short time window to extract the waveform features. This approach enables the detection of the fault features before MMC blocking in the worst-case fault scenario and prevents the incorrect fault identification caused by the minor amplitude of fault current provided bv the converters. A detailed model of an offshore wind farm connected to the MMC-HVDC system is established in the real-time digital simulator (RTDS).

Document US 10985558 B1 provides a novel principle of pilot protection based on structural similarity and square error criteria. The structural similarity criterion utilizes the difference of fault characteristics between renewable sources and synchronous generators to identify internal faults, and the square error criterion is used to solve abnormal calculation of the conventional similarity based protection.

### SUMMARY

The present invention, hereby indicated as "the present disclosure", is set out in the appended set of claims.

The present disclosure provides a fault identification method based on full-time-domain abrupt change information, a system, an electronic device, and a computer-readable storage medium. When the high-voltage AC line fails, the current signals on the wind farm side and the flexible DC side are collected, and a respective fault current of each phase on the wind farm side and the flexible DC side are acquired. For each fault current of a respective phase on the wind farm side and the flexible DC side, a respective multi-order matrix is constructed according to the fault current of the phase on the wind farm side and the flexible DC side, and according to the multi-order matrixes, a respective abrupt change characteristic value corresponding to the fault current of the phase on the wind farm side and the flexible DC side is calculated. A respective fault type is determined according to a preset criterion and the abrupt change characteristic value corresponding to the fault current of the phase on the wind farm side and the flexible DC side. According to the method of the present disclosure, the current signals of the phases on both sides of the line are used to construct multi-order matrixes respectively. The characteristic that the multi-order matrix may quickly amplify the proportion of abrupt change signals and the advantage that the matrix gradient may accurately represent the degree of the abrupt change of data are comprehensively used to construct the protection criterion, so as to achieve the high-speed and reliable fault identification, thereby solving the problem of the risk of sensitivity decrease of conventional protection and the risk of incorrect operation in the new power system. The present disclosure may adapt to a scenario of access and delivery of multiple types of new energy power supplies without depending on the power frequency quantity, and have a capacity to withstand the transition resistance and noise and a rapid responsiveness, which has an important engineering significance for the high proportion consumption of the future new energy and the safe operation of the power grid, and provides the premise and guarantee for further development of the new energy power electronic system with a high proportion in the future.

### BRIEF DESCRIPTION OF THE DRAWINGS

Exemplary implementations of the present disclosure may be more completely understood with reference to the following drawings.
FIG. 1 is a flowchart of a fault identification method based on full-time-domain abrupt change information provided by an implementation of the present disclosure.
FIG. 2 is a flowchart of protection provided by an implementation of the present disclosure.
FIG. 3 is a schematic diagram of incorporating a fan incorporated an AC system provided by an implementation of the present disclosure.
FIG. 4 is a schematic diagram of a protection operation situation when different fault types of faults occur at F2 within a region provided by an implementation of the present disclosure.
FIG. 5 is a schematic diagram of a protection operation situation when different fault types of faults occur at F3 within a region provided by an implementation of the present disclosure.
FIG. 6 is a schematic diagram of a protection operation situation when different fault types of faults occur at F4 within a region provided by an implementation of the present disclosure.
FIG. 7 is a schematic diagram of a protection operation situation when different fault types of faults occur at F1 outside a region provided by an implementation of the present disclosure.
FIG. 8 is a comparison diagram of protection effects of a protection method provided by an implementation of the present disclosure and a conventional protection method.
FIG. 9 is a schematic diagram of a structure of a fault identification system based on full-time-domain abrupt change information provided by an implementation of the present disclosure.
FIG. 10 is a schematic diagram of a structure of an electronic device provided by an implementation of the present disclosure.

### DETAILED DESCRIPTION

Exemplary implementations of the present disclosure are now introduced with reference to the drawings. However, the present disclosure may be implemented in many different forms and is not limited to the embodiments described herein. The embodiments are provided to fully and completely disclose the present disclosure and to fully communicate the scope of the present disclosure to those skilled in the technical field to which they belong. Terms in the exemplary implementations expressed in the drawings are not limitations on the present disclosure. In the drawings, the same units/components use the same reference.

Unless otherwise illustrated, terms used herein (including technical terminologies) have general meanings understood by those skilled in the technical field to which they belong. In addition, it is to be understood that a term limited by a commonly used dictionary should be understood to have a meaning consistent with the context of the related field thereof, and should not be understood as an idealized or too formal meaning.

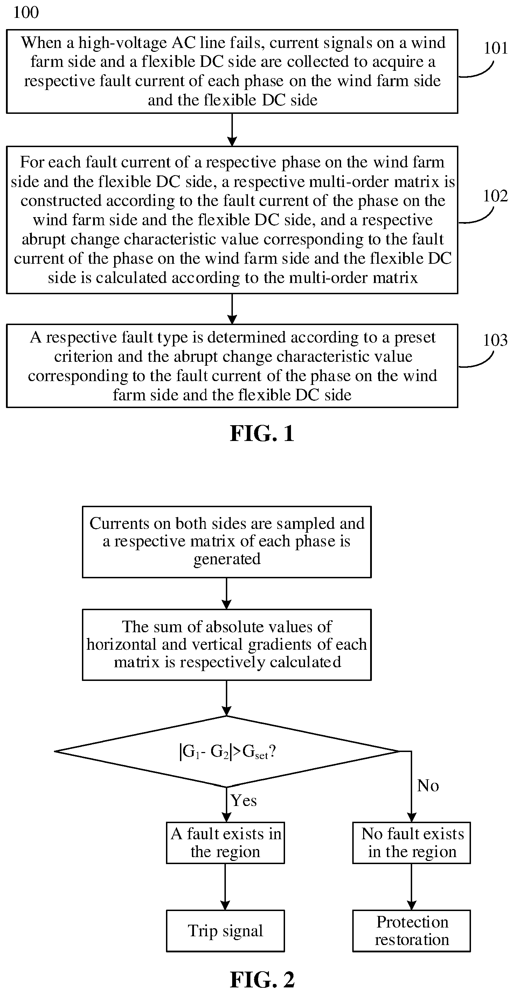

In the new power system, since the fault characteristics are affected by the control strategy of the power electronic apparatus, the short-circuit current presents characteristics such as limited amplitude, non-power frequency, controlled phase angle, or the like, which are completely different from those of a synchronous generator. As a result, it is difficult for conventional differential protection to quickly extract a continuous and stable power frequency component in a scenario that the short-circuit current is controlled, so that a risk of sensitivity decrease or even incorrect operation will occur, thereby affecting the safe operation of the power system. Therefore, the study of a new protection principle that is not affected by the control of the power electronic apparatus is of great significance for safe and stable operation of large-scale new energy grid-connection in the future. FIG. 1 is a flowchart of a fault identification method 100 based on full-time-domain abrupt change information according to an implementation of the present disclosure. As shown in FIG. 1, according to the fault identification method based on the full-time-domain abrupt change information provided by the implementation of the present disclosure, the current signals of the phases on both sides of the line are used to construct multi-order matrixes respectively. The characteristic that the multi-order matrix may quickly amplify the proportion of abrupt change signals and the advantage that the matrix gradient may accurately represent the degree of the abrupt change of data are comprehensively used to construct the protection criterion, so as to achieve the high-speed and reliable fault identification, thereby solving the problem of the risk of sensitivity decrease of conventional protection and the risk of incorrect operation in the new power system. The present disclosure may adapt to a scenario of access and delivery of multiple types of new energy power supplies without depending on the power frequency quantity, and have a capacity to withstand the transition resistance and noise and a rapid responsiveness, which has an important engineering significance for the high proportion consumption of the future new energy and the safe operation of the power grid, and provides the premise and guarantee for further development of the new energy power electronic system with a high proportion in the future.

Referring to FIG. 1, the fault identification method 100 based on the full-time-domain abrupt change information provided by the implementation of the present disclosure may be achieved by the following operations.

In operation 101, when a high-voltage AC line fails, current signals on a wind farm side and a flexible DC side are collected to acquire a respective fault current of each phase on the wind farm side and the flexible DC side.

In the embodiments of the present disclosure, the fault current of the phase on the wind farm side may be represented by the following formula 1. $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right)\end{matrix}$ (formula 1)

The fault current of the phase on the flexible DC side may be represented by the following formula 2. ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right)$ (formula 2)

Here, *i_{wφ}* denotes a fault current of a phase *φ* on the wind farm side. ${i}_{d}^{*}$ denotes a preset current reference value of a d-axis, and ${i}_{q}^{*}$ denotes a preset current reference value of a q-axis. *ω_{PLL}* denotes a fundamental angular frequency. *θ_{φ}* denotes an initial phase angle. *ξ* denotes a damping ratio of a second-order system, *ξ* = *kᵢₚ* / 2× (*L*× *kᵢᵢ*)^{1/2}. *ω_{d}* denotes a damped natural frequency, *ω_{d} = ωₙ*(1-*ξ*²)^{1/2}, and *ωₙ* denotes a natural oscillation angular frequency when a damping of the second-order system is zero, *ωₙ* (*kᵢᵢ* / *L*)^{1/2}. *β* denotes a damping angle of a system, *β* = arctan((1-*ξ*²)^{1/2}/*ξ*). P denotes a single-phase output active power. *u_{d}* denotes a voltage of the d-axis. *i*_{*d*0} denotes an initial current of the d-axis. t denotes fault time. *kᵢₚ* denotes a ratio of a current control loop. *kᵢᵢ* denotes an integral time constant. L denotes a bridge arm inductance.

Here, *i_{mmcφ}* denotes a fault current of the phase *φ* on the flexible DC side. *E_{f}* denotes an electric potential within a converter. *Z_{eq}* denotes an equivalent impedance. ω denotes an angular frequency of a positive sequence current, and *ω*⁻ denotes an angular frequency of a negative sequence current. m denotes a ratio coefficient related to a short-circuit type. *θ*_{*φ*-} denotes an initial phase angle of the negative sequence current.

In the embodiments of the present disclosure, firstly, fault characteristics of in-region and out-of-region faults of the AC line on which the new energy is sent through the grid-connection on the flexible DC side are analyzed to clarify characteristics of in-region and out-of-region fault currents. Then, single-phase current signals collected within time windows on both sides are constructed into a multi-order matrix. The wind power converter is the only power outlet of the permanent magnet fan. Due to a limited overcurrent capacity, in order to protect the power electronic components of the converter, the control system mainly uses amplitude limit control and negative sequence current control. The short-circuit current of each phase on the wind farm side may be represented by the above formula 1.

As shown in the above formula 1, the short-circuit current of the wind farm is controlled by the reference values of the currents of the d-axis and q-axis of the control system of the converter, and the wind farm is equivalent to a controlled current source. Due to a limited capacity of the converter to withstand overcurrent, the short-circuit current is generally 1.5-2 times the maximum rated current. Therefore, the wind farm has a characteristic of limited amplitude of the fault current.

In some embodiments, since the converter at the sending end on the flexible DC side is coupled to a controlled current source, it is generally controlled by AC voltagefrequency and is equivalent to a controlled voltage source. The fault current before the converter at the sending end on the flexible DC side is blocked may be represented by the above formula 2.

As can be known from the above formula 2, when a fault occurs, the short-circuit current provided by the flexible DC converter has a positive sequence component and a negative sequence component simultaneously. The converter is equivalent to a controlled voltage source, and the amplitude of the short-circuit current depends on the equivalent internal potential and equivalent impedance of the flexible DC converter.

According to the above analysis of the fault characteristics of the converter, it can be known that the fault current of the converter has a limited amplitude and lacks a continuous and stable power frequency component, which seriously affects the correct fault identification of the conventional current differential protection principle. Sensitivity will decrease during the calculation process of the protection apparatus, and there is a risk of incorrect operation. In addition, different converter control reflects different control response characteristics, which thus determines that the abrupt change characteristics of the short-circuit current after the fault are different and are all different from those of a conventional synchronous machine.

In operation 102, for each fault current of a respective phase on the wind farm side and the flexible DC side, a respective multi-order matrix is constructed according to the fault current of the phase on the wind farm side and the flexible DC side, and a respective abrupt change characteristic value corresponding to the fault current of the phase on the wind farm side and the flexible DC side is calculated according to the multi-order matrix.

In the embodiments of the present disclosure, the operation that the respective multi-order matrix is constructed according to the fault current of the phase on the wind farm side and the flexible DC side, and the respective abrupt change characteristic value corresponding to the fault current of the phase on the wind farm side and the flexible DC side is calculated according to the multi-order matrix includes the following operations.

The following operations are performed for the fault current of the phase on the wind farm side and the flexible DC side to acquire the abrupt change characteristic value corresponding to the fault current of the phase on the wind farm side and the flexible DC side.

Sample values of a fault current of any phase are determined as an one-dimensional array, and a current signal composed of N sampling points within sampling time is denoted as *I* = {*i*₁*, i*₂*, i*₃*, ···, i_{N}*}*.* The multi-order matrix may be represented by the following formula 3. ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)}$ (formula 3)

The multi-order matrix *I_{T}* is transformed into expressions of row vectors and column vectors. The expression of the column vectors is *I_{T}* = {*I*₁,*I*₂,*I*₃,···,*I_{N}*}*,* and internal elements of the first column vector are *I*₁ = {*i*₁*,i*₂*,i*₃*,*···, *i^{N}*}*^{T}*. The expression of the row vectors is *I_{T} =*{*I*₁*^{T},I*₂*^{T},I*₃*^{T},*···*, I_{N}^{T}*}*^{T}*, and internal elements of the first row vector are *I*₁*^{T} =*{*i*₁*,i*₂*,i*₃*,*···*,i_{N}*}.

A horizontal gradient matrix corresponding to the multi-order matrix with the expression of the column vectors is calculated. The horizontal gradient matrix may be obtained by the following formula 4. $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right]$ (formula 4)

A vertical gradient matrix corresponding to the multi-order matrix with the expression of the row vectors is calculated. The vertical gradient matrix may be obtained by the following formula 5. $Gy = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2} … \frac{{I}_{N}^{T} - {I}_{N - 1}^{T}}{1}\right]}^{T}$ (formula 5)

The abrupt change characteristic value is calculated according to the horizontal gradient matrix and the vertical gradient matrix. The abrupt change characteristic value may be obtained by the following formula 6. $G = {\sum }_{i = 1}^{N} {\sum }_{j = 1}^{N} \left(\left|Gx\left(i, j\right)\right|+\left|Gy\left(i, j\right)\right|\right)$ (formula 6)

Here, G denotes the abrupt change characteristic value corresponding to the fault current of the phase. *Gx* denotes the horizontal gradient matrix, and *Gy* denotes the vertical gradient matrix. *Gx*(*i, j*) denotes an element in an i-th row and a j-th column of the horizontal gradient matrix. *Gy*(*i, j*) denotes an element in an i-th row and a j-th column of the vertical gradient matrix.

In the embodiments of the present disclosure, current sample values of any phase on both sides of the line may be regarded as an one-dimensional array, i.e., a current signal of N sampling points during a period of time constitutes the one-dimensional data I, which is denoted as *I* ={*i*₁,*i*₂,*i*₃*,*···,*i_{N}*}.

The obtained one-dimensional data I constituted by the current signal of the N sampling points is improved to obtain a multi-order matrix *I_{T}.* The improvement manner is as follows.

An empty matrix of N×N is constructed, and all signal elements in the first row of the matrix are arranged orderly in a chronological order starting from *i*₀. Due to the symmetry of the matrix, like the first row, the first column is also arranged orderly starting from *i*₀. From the second row, the element at each position is the same as the element at its upper-left corner until the entire N×N matrix is filled. The matrix adopts a symmetric configuration, which makes it conform to the definition of a symmetric matrix *I_{T}=I_{T}^{T}*, and each element is the same as the element at its upper-left corner. When all signal elements in the matrix are arranged according to the rule, the multi-order matrix *I_{T}* is obtained.

It is to be noted that when a fault occurs, there will be a short-term abrupt change of the current. Therefore, the current signal after the fault will have a larger step jump compared to the previous signal. In addition, the concept of matrix gradient is introduced in order to represent the degree of the abrupt change with specific numerical values.

The matrix gradient is divided into transverse gradient and longitudinal gradient, which mainly reflects the degree of change between adjacent elements in the matrix. Taking the multi-order matrix *I_{T}* as an example, it is converted into an expression of column vectors.

The expression of the column vectors is *I_{T}* ={*I*₁,*I*₂,*I*₃,···, *I_{N}*}, and the internal elements of the first column vector are *I*₁ ={*i*₁*,i*₂*,i*₃*,*···,*i_{N}*}*^{T}*. The difference between the first column vector and the next column vector of the current matrix is divided by 1 to obtain the first column vector of the horizontal gradient matrix. The average of the differences between the n-th column vector in the middle and the current column vectors on both sides is taken as the n-th column vector of the horizontal gradient matrix. The difference between the last column vector and the previous column vector is taken as the last column vector of the horizontal gradient matrix. The expression of the horizontal gradient matrix *Gx* is as follows. $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right]$

Similarly, the expression of the row vectors is *I_{T}* ={*I*₁*^{T},I*₂*^{T},I*₃*^{T},*···*,I_{N}^{T}*}*^{T}*, and the internal elements of the first row vector are *^{I}*₁*^{T}* ={*i*₁,*i*₂,*i*₃,···,*i_{N}*}. Then, the difference between the first row vector and the next row vector of the current matrix is divided by 1 to obtain the first row vector of the vertical gradient matrix. The average of the differences between the n-th row vector in the middle and the current row vectors on both sides is taken as the n-th row vector of the vertical gradient matrix. The difference between the last row vector and the previous row vector is taken as the last row vector of the vertical gradient matrix. The expression of the vertical gradient matrix Gy is as follows. $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T}$

For any phase, after the horizontal gradient matrix *Gx* and the vertical gradient matrix *Gy* are acquired, absolute values are taken for the obtained horizontal gradient matrix *Gx* and the vertical gradient matrix *Gy,* and the sum of all elements in the two matrixes is calculated as the abrupt change characteristic value of the signal collected within the time window. Then, the abrupt change characteristic value G corresponding to the current signal of any phase may be obtained, which is expressed as follows. $G = {\sum }_{i = 1}^{N} {\sum }_{j = 1}^{N} \left(\left|Gx\left(i, j\right)\right|+\left|Gy\left(i, j\right)\right|\right)$

That is, the abrupt change characteristic value G of each time window is taken to reflect the abrupt change characteristic value of the signal. Here, G denotes the abrupt change characteristic value corresponding to the fault current of the phase. *Gx* denotes the horizontal gradient matrix, and *Gy* denotes the vertical gradient matrix. *Gx*(*i, j*) denotes an element in the i-th row and the j-th column of the horizontal gradient matrix. *Gy*(*i, j*) denotes an element in the i-th row and the j-th column of the vertical gradient matrix.

In the embodiments of the present disclosure, the fault current of the phase on the wind farm side and the flexible DC side corresponds to an abrupt change characteristic value.

In operation 103, a respective fault type is determined according to a preset criterion and the abrupt change characteristic value corresponding to the fault current of the phase on the wind farm side and the flexible DC side.

In the embodiments of the present disclosure, the operation that the respective fault type is determined according to the preset criterion and the abrupt change characteristic value corresponding to the fault current of the phase on the wind farm side and the flexible DC side includes the following operations.

For any phase, if fault currents on the wind farm side and the flexible DC side corresponding to the phase meet the preset criterion, a fault type of the phase is determined as an in-region fault.

If the fault currents on the wind farm side and the flexible DC side corresponding to the phase do not meet the preset criterion, the fault type of the phase is determined as an out-of-region fault.

The preset criterion includes Δ*G=*|*G*₁*-G*₂|>*Gₛₑₜ.* Here, *G*₁ denotes the abrupt change characteristic value corresponding to the fault current of the phase on the wind farm side, *G*₂ denotes the abrupt change characteristic value corresponding to the fault current of the phase on the flexible DC side, and *Gₛₑₜ* denotes a preset setting value.

In other embodiments of the present disclosure, a phase with the fault type of an in-region fault is determined as a fault phase, and an exit is protected according to the number of the fault phases.

Here, if the number of the fault phases is less than or equal to a preset number, a relay protection apparatus is controlled to send a fault phase trip instruction to control the fault phase to trip and control a non-fault phase to operate normally. If the number of the fault phases is greater than the preset number, the relay protection apparatus is controlled to send a three-phase trip instruction to control all of three phases to trip.

In the embodiments of the present disclosure, it is necessary to make use of the different multi-dimensional abrupt change characteristic values of the current signal when an in-region fault occurs to construct a criterion, and then to identify the fault type by comparing the size relationship between the actual operational value in the criterion and the setting value, so that corresponding protection measures are enabled according to the fault type.

During the normal steady state operation, power of the wind farm completely flows to the flexible DC side through the line. In such case, all current flowing through the line is through-current, and AC currents collected on both sides of the line are the same sine wave. Therefore, the abrupt change characteristic values G of the current signals collected on both sides in the same time window should also be basically the same.

In case of an in-region fault, due to the difference in control strategy and adjustment speed, the fault currents on both sides will be greatly adjusted in a short time after the fault occurs. The abrupt change characteristic value of the whole time window will change in a short time due to the collected fault point, and the changes in the current signals collected on both sides are different. The calculated abrupt change characteristic values G will be significantly different.

In case of an out-of-region fault, the through-current also flows through the protected line. Therefore, the abrupt change characteristic values G of the multi-order matrix gradient of the in-phase current signals on both sides should be the same. Theoretically, the difference between the abrupt change characteristic values G of the current signals collected on both sides should approach zero.

Therefore, according to the above fault characteristic analysis, the protection criterion may be constructed as follows. $Δ G = \left|{G}_{1}-{G}_{2}\right| > {G}_{set}$

Here, each of *G*₁ and *G*₂ denotes a respective one of the abrupt change characteristic values corresponding to the current signals at both ends of the line, and |•| denotes taking the absolute value. *Gₛₑₜ* denotes the setting value of the main criterion of the protection, which is set according to the maximum amplitude error when the external fault is avoided. Considering that the maximum transmission error of the Current transformer (CT) is ±10% and the capacitor has a small influence on the fault current, the maximum amplitude error on both sides is set to 20%, and a certain margin is retained considering special circumstances. In the embodiments of the present disclosure, in order to ensure that the number of sampling points meets the calculation requirements, the shorter the time window is, the higher the sampling frequency is required. However, it is difficult for an industrial application to achieve a high sampling frequency. Therefore, current signals within a time window of 10ms are adopted to construct a multi-order matrix, and the sum of the absolute values of the matrix gradient is obtained to determine the multi-abrupt change characteristic value.

In combination with FIG. 2, in the embodiments of the present disclosure, the fault type is identified by comparing the size relationship between the actual operational value |*G*₁ -*G*₂| of the criterion and the setting value Gset, and corresponding protection measures are enabled according to the fault type. The specific process is as follows. After the protection is started, each set of protection apparatus judges the fault phase by phase, extracts the differential current data 10ms after the fault moment, and performs calculation according to the proposed protection criterion. For any phase, if the formula of the protection criterion is met, i.e., the difference between the multi-dimensional abrupt change characteristic values is greater than the setting value, the fault type is determined to be an in-region fault, and the exit is protected. Otherwise, the fault type is determined to be an out-of-region fault, and the protection is restored.

It is to be noted that after the fault type is determined, a phase with the fault type of the in-region fault is determined to be a fault phase. If the fault phase is a single phase, the relay protection apparatus sends the fault phase trip instruction, and the non-fault phase continues to operate. If two or three phases meet the criterion, the relay protection apparatus sends the three-phase trip instruction to control all the three phases to trip.

After the large-scale new energy is incorporated into the power grid, the sensitivity of the conventional protection decreases. In order to ensure safe and reliable operation of the system, the method proves that there is an obvious difference between the abrupt change characteristic values in case of in-region and out-of-region faults by theoretical analysis and simulation verification. Finally, a high-voltage AC line protection method adopting the multi-dimensional abrupt change information is proposed. The method provided by the embodiments of the present disclosure solves the problem of the risk of sensitivity decrease and incorrect operation of the conventional protection, which is caused by the fact that the fault current is controlled and can not provide a continuous and stable power frequency component, and the method is applicable to different types of new energy stations. The method provided by the embodiments of the present disclosure has the following characteristics.
1) A high speed. The time for protecting the exit is within 5ms.
2) High reliability. The protection constructs the protection criterion by the difference between multi-dimensional abrupt change characteristic values of the short-circuit currents on both sides after the region fault, which is not affected by the characteristics of the power supplies on both sides, and may still correctly operate in case of noise greater than 30dB. Compared with the conventional differential protection, in a twoside controlled scenario that the new energy is connected to a flexible DC system, high sensitivity may still be ensured to achieve the reliable operation.
3) Strong tolerance for the transition resistance. The protection may still correctly operate in case of transition resistance of 100Ω.

In the following, the implementations of the present disclosure are specifically illustrated with examples.

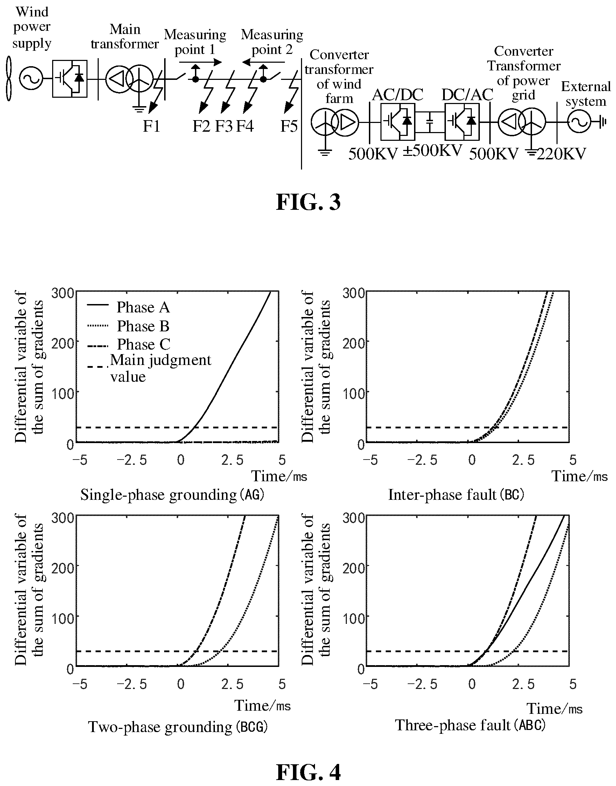

The grid-connection system shown in FIG. 3, in which a direct-drive wind farm with a rated voltage of 220 kilovolt (kV) is connected to the grid through a ±500kV flexible DC transmission line, is built in a Power Systems Computer Aided Design (PSCAD) or an Electromagnetic Transients including DC (EMTDC). The system capacity is 200 megavoltampere (MVA). The wind farm is equivalent to a single fan, and the capacity of the single fan of a wind turbine is 5 million watt (MW). The length of the AC line from the transformer of the wind farm to the converter at the flexible DC sending end is 20 kilometers (km).

As shown in FIG. 3, five fault points are set on the AC line. Here, F1 and F5 are out-of-region fault points, and in-region internal faults include an outlet of the protection line on the wind farm side F2, an outlet of the line on the flexible DC side F4, and a fault at the middle point of the line F3. The sampling frequency of the current signal is 4kHz, and the time window is selected to be 10ms.

The setting value should be set to avoid the maximum amplitude error when an external fault occurs. The maximum transmission error of the CT is ±10%, and the maximum amplitude error on both sides is 20%. Although the influence of the capacitor current is small, the influence of the capacitor current is avoided by an adjustable margin. The margin herein is set to 20% and may be adjusted according to actual system parameters. When there is an error of 20% amplitude on both sides, the difference between the abrupt change characteristic values G increases to 30 in case of an external fault. Therefore, the constant value of *Gₛₑₜ* is set to 30.

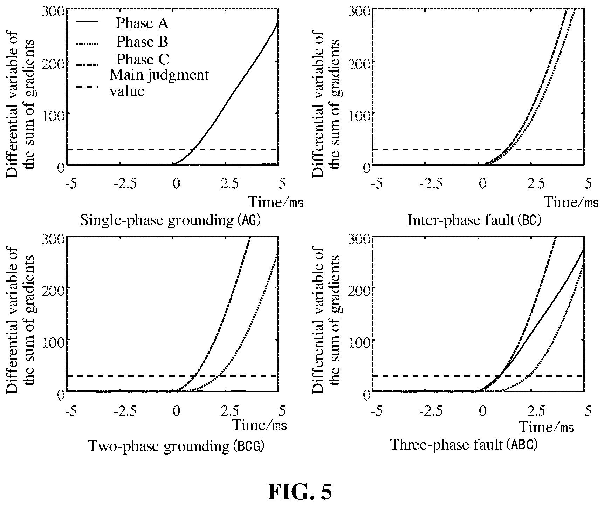

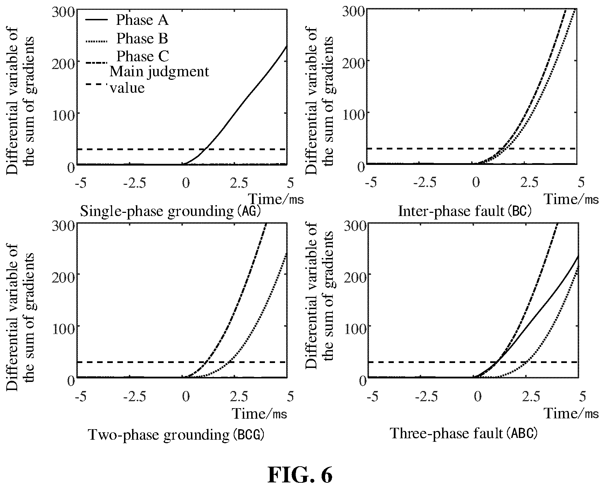

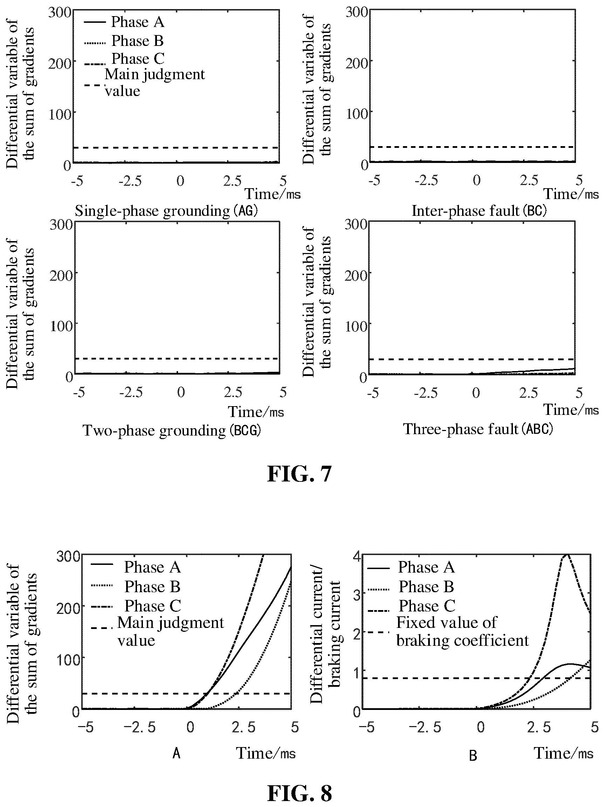

FIG. 4 illustrates a schematic diagram of a corresponding protection operation situation when faults of different fault types occur at F2 within the region. FIG. 5 illustrates a schematic diagram of a corresponding protection operation situation when faults of different fault types occur at F3 within the region. FIG. 6 illustrates a schematic diagram of a protection operation situation when faults of different fault types occur at F4 within the region. FIG. 7 illustrates a schematic diagram of a protection operation situation when faults of different fault types occur at F1 outside the region. In addition, Table 1 provides the differences between abrupt change characteristic values of protection of faults of different fault types at the positions of F2, F3 and F4 within the region and at the positions of F1 and F5 outside the region at the time of 5ms.

As can be seen from FIG. 4 to FIG. 7, the proposed protection principle has a good operation performance in different scenarios (different fault types and different fault positions). In case of an in-region fault, the difference between the abrupt change characteristic values of the fault phase is greater than the setting value of the protection criterion within 5ms, and the protection reliably operates. In case of an out-of-region fault, both the fault phase and the non-fault phase do not exceed the fixed value, and the protection does not operate, which verifies effectiveness of the proposed protection.

In order to verify adaptability to the transition resistance of the proposed protection, taking an in-region fault occurring at F3 as an example, a grounding fault of phase A and a fault between phases B and C in case of the transition resistance of 25Ω, 50Ω, 75Ω and 100Ω are analyzed respectively. Table 2 respectively provides the differential variable of the abrupt change characteristic value of the proposed protection in case of a grounding fault of a single phase and a fault between two phases through the transition resistance.

As can be seen from Table 2, with the increase of the transition resistance, the degree of abrupt change of the current signal gradually decreases, the difference between the abrupt change characteristic values of the current signals on both sides decreases, and thus the differential variable of the abrupt change characteristic value decreases. Although there is a trend of sensitivity decrease, the proposed protection may still reliably reflect the fault in a scenario of a high-resistance fault of 100Ω. Considering that the maximum transition resistance of the 220kV system is 100Ω, the above results may basically satisfy a good performance of the proposed protection in a scenario of a high-resistance fault.

Table 3 provides the operation performance of the protection after 5ms in different noise scenarios when a fault occurs at F3. As can be seen from Table 3, the increase of noise has a small influence on the fault phase, and the protection may correctly reflect the fault. For the non-fault phase, the increase of noise will lead to a difference between the currents on both sides, which will lead to an increasing trend of the differential variable of the singular value, but it is still far below the setting value. In a scenario of high noise of 30dB, the protection may still distinguish the fault type correctly, which may prove that the proposed method has a good anti-noise capacity.

**Table 1**

| Position of the fault | Fault type | Differential variable of the sum of matrix gradients | | |
|---|---|---|---|---|
| | | phase A | phase B | phase C |
| F1 outside the region | AG | 1.1093 | 0.3083 | 2.6746 |
| | BC | 0.0683 | 0.5035 | 2.7304 |
| | BCG | 0.0326 | 0.7884 | 3.2169 |
| | ABC | 1.3819 | 0.3360 | 2.8849 |
| F2 within the region | AG | 329.6329 | 0.6306 | 2.7372 |
| | BC | 0.0388 | 415.2399 | 477.2263 |
| | BCG | 0.0074 | 299.1895 | 589.1131 |
| | ABC | 322.0450 | 283.7939 | 578.7273 |
| F3 within the region | AG | 274.1122 | 0.4319 | 2.4152 |
| | BC | 0.4771 | 357.4110 | 420.7332 |
| | BCG | 0.4566 | 269.8290 | 502.3697 |
| | ABC | 275.6890 | 247.6260 | 502.1424 |
| F4 within the region | AG | 229.6152 | 0.7089 | 1.7320 |
| | BC | 0.0238 | 309.5809 | 369.2010 |
| | BCG | 0.0176 | 241.2244 | 432.2286 |
| | ABC | 235.7391 | 215.8061 | 434.2341 |
| F5 outside the region | AG | 0.4958 | 0.7730 | 1.4338 |
| | BC | 0.0357 | 2.5299 | 1.0093 |
| | BCG | 0.0026 | 2.7582 | 1.1949 |
| | ABC | 0.4935 | 0.6234 | 1.2300 |

**Table 2**

| Fault type | Transition resistance | Differential variable of the sum of matrix gradients | | |
|---|---|---|---|---|
| | | phase A | phase B | phase C |
| AG | 25 | 155.4939 | 0.8312 | 2.2760 |
| | 50 | 100.5921 | 0.6747 | 2.1096 |
| | 75 | 66.1646 | 0.6840 | 1.9903 |
| | 100 | 43.8104 | 0.6809 | 1.3126 |
| BC | 25 | 0.0520 | 206.7200 | 266.7406 |
| | 50 | 0.0660 | 126.2392 | 183.4578 |
| | 75 | .0.0595 | 80.4747 | 133.6495 |
| | 100 | 0.0591 | 50.9774 | 99.0760 |

**Table 3**

| Fault type | Noise/dB | Differential variable of the sum of matrix gradients | | |
|---|---|---|---|---|
| | | phase A | phase B | phase C |
| AG | 45 | 273.8621 | 0.7459 | 2.5993 |
| | 40 | 276.4090 | 0.5926 | 0.9535 |
| | 35 | 277.6658 | 1.4303 | 1.7124 |
| | 30 | 289.5017 | 3.3969 | 0.0443 |
| BC | 45 | 0.5502 | 355.7312 | 417.5339 |
| | 40 | 0.5434 | 356.3787 | 416.0372 |
| | 35 | 2.9428 | 358.7848 | 422.1961 |
| | 30 | 0.9797 | 365.9244 | 423.5883 |
| BCG | 45 | 0.2968 | 267.2786 | 502.0055 |
| | 40 | 1.0372 | 268.8163 | 499.9201 |
| | 35 | 0.9865 | 266.0051 | 495.1179 |
| | 30 | 2.8042 | 290.2767 | 511.2617 |
| ABC | 45 | 275.1948 | 246.2816 | 499.3576 |
| | 40 | 278.1949 | 245.7893 | 499.3585 |
| | 35 | 271.0604 | 238.2753 | 502.9533 |
| | 30 | 297.1087 | 258.4139 | 512.8152 |

In order to test superiority of the proposed protection, as shown in FIG. 8, the operation performance of the protection method provided by the embodiments of the present disclosure (e.g., A in FIG. 8) is compared with the protection method of the conventional differential protection method (e.g., B in FIG. 8). When a fault occurs among the three phases, the protection starting speed of the conventional differential protection based on the power frequency is slow within 5ms, and there is an obvious trend of falling back in phase A at 5ms. The ratio of the differential current of the protection of the exit to the braking current barely exceeds the setting value, the sensitivity seriously decreases, and there is a risk of failure to actuate. The new protection principle proposed herein has faster fault response and higher sensitivity within 5ms, which may quickly identify faults and may still ensure a normal performance in the scenarios of the noise and the resistance grounding.

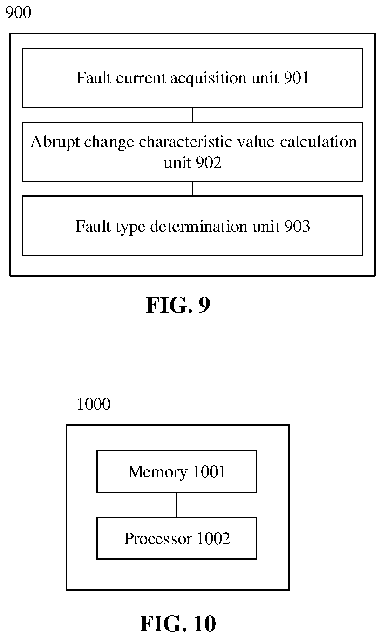

The present disclosure proposes the concept of multi-order matrix transformation of the current sampling data. The multi-order matrix transformation may quickly amplify the proportion of the abrupt change signal of the fault current, which fundamentally solves the problem of "weakness" of the fault characteristics of the power electronic components. The present disclosure proposes to construct a protection criterion by the advantage that the matrix gradient may accurately represent the degree of the abrupt change of the data, so as to achieve the high-speed and reliable identification of the fault, thereby solving the problem of sensitivity decrease of the conventional protection in the new power system. FIG. 9 is a schematic diagram of a structure of a fault identification system 900 based on full-time-domain abrupt change information according to an implementation of the present disclosure. As shown in FIG. 9, the fault identification system 900 based on the full-time-domain abrupt change information provided by the implementation of the present disclosure includes a fault current acquisition unit 901, an abrupt change characteristic value calculation unit 902 and a fault type determination unit 903.

The fault current acquisition unit 901 is configured to collect, when a high-voltage AC line fails, current signals on a wind farm side and a flexible DC side, to acquire a respective fault current of each phase on the wind farm side and the flexible DC side.

The abrupt change characteristic value calculation unit 902 is configured to: for each fault current of a respective phase on the wind farm side and the flexible DC side, construct a respective multi-order matrix according to the fault current of the phase on the wind farm side and the flexible DC side, and calculate, according to the multi-order matrix, a respective abrupt change characteristic value corresponding to the fault current of the phase on the wind farm side and the flexible DC side.

The fault type determination unit 903 is configured to determine a respective fault type according to a preset criterion and the abrupt change characteristic value corresponding to the fault current of the phase on the wind farm side and the flexible DC side.

In some embodiments, at the fault current acquisition unit 901, the fault current of the phase on the wind farm side is: $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right)\end{matrix}$

The fault current of the phase on the flexible DC side is: ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right)$

Here, *i_{wφ}* denotes a fault current of a phase *φ* on the wind farm side. ${i}_{d}^{*}$ denotes a preset current reference value of a d-axis, and ${i}_{q}^{*}$ denotes a preset current reference value of a q-axis. *ω_{PLL}* denotes a fundamental angular frequency. *θ_{φ}* denotes an initial phase angle. *ξ* denotes a damping ratio of a second-order system, *ξ=kᵢₚ*/2×(*L*×*kᵢᵢ*)^{1/2}. *ω_{d}* denotes a damped natural frequency, *ω_{d}* = *ωₙ*(1-*ξ*²)^{1/2}, and *ωₙ* denotes a natural oscillation angular frequency when a damping of the second-order system is zero, *ωₙ* =(*kᵢᵢ*/*L*)^{1/2}. *β* denotes a damping angle of a system, *β* = arctan((1-*ξ*²)^{1/2}/ξ). P denotes a single-phase output active power. *u_{d}* denotes a voltage of the d-axis. *i*_{*d*0} denotes an initial current of the d-axis. t denotes fault time. *kᵢₚ* denotes a ratio of a current control loop. *kᵢᵢ* denotes an integral time constant. L denotes a bridge arm inductance.

Here, *i_{mmcφ}* denotes a fault current of the phase *φ* on the flexible DC side. *E_{f}* denotes an electric potential within a converter. *Z_{eq}* denotes an equivalent impedance. ω denotes an angular frequency of a positive sequence current, and *ω⁻* denotes an angular frequency of a negative sequence current. m denotes a ratio coefficient related to a short-circuit type. *θ_{φ}*⁻ denotes an initial phase angle of the negative sequence current.

In some embodiments, the abrupt change characteristic value calculation unit 902 is further configured to perform the following operations for the fault current of the phase on the wind farm side and the flexible DC side to acquire the abrupt change characteristic value corresponding to the fault current of the phase on the wind farm side and the flexible DC side.

Sample values of a fault current of any phase are determined as an one-dimensional array, and a current signal composed of N sampling points within sampling time is denoted as *I* ={*i*₁,*l*₂,*i*₃,···,*i_{N}*}. The multi-order matrix is: ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)}$

The multi-order matrix *I_{T}* is transformed into expressions of row vectors and column vectors. The expression of the column vectors is *I_{T}* ={*I*₁,*I*₂,*I*₃,···,*I_{N}*}, and internal elements of the first column vector are *I*₁ ={*i*₁,*i*₂,*i*₃,···,*i_{N}*}*^{T}*. The expression of the row vectors is *I_{T}* ={*I*₁*^{T}*,*I*₂*^{T}*,*I*₃*^{T}*,···,*I_{N}^{T}*}*^{T}*, and internal elements of the first row vector are *I*₁*^{T}* ={*i*₁,*i*₂,*i*₃,···,*i_{N}*}*.*

A horizontal gradient matrix corresponding to the multi-order matrix with the expression of the column vectors is calculated, including: $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right]$

A vertical gradient matrix corresponding to the multi-order matrix with the expression of the row vectors is calculated, including: $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T}$

The abrupt change characteristic value is calculated according to the horizontal gradient matrix and the vertical gradient matrix, including: $G = {\sum }_{i = 1}^{N} {\sum }_{j = 1}^{N} \left(\left|Gx\left(i, j\right)\right|+\left|Gy\left(i, j\right)\right|\right)$

Here, G denotes the abrupt change characteristic value corresponding to the fault current of the phase. *Gx* denotes the horizontal gradient matrix, and *Gy* denotes the vertical gradient matrix. *Gx*(*i, j*) denotes an element in an i-th row and a j-th column of the horizontal gradient matrix. *Gy*(*i, j*) denotes an element in an i-th row and a j-th column of the vertical gradient matrix.

In some embodiments, the fault type determination unit 903 is further configured to: for any phase, if fault currents on the wind farm side and the flexible DC side corresponding to the phase meet the preset criterion, determine a fault type of the phase as an in-region fault; and

if the fault currents on the wind farm side and the flexible DC side corresponding to the phase do not meet the preset criterion, determine the fault type of the phase as an out-of-region fault.

The preset criterion includes Δ*G*=|*G*₁*-G*₂|>*Gₛₑₜ.* Here, *G*₁ denotes the abrupt change characteristic value corresponding to the fault current of the phase on the wind farm side, *G*₂ denotes the abrupt change characteristic value corresponding to the fault current of the phase on the flexible DC side, and *Gₛₑₜ* denotes a preset setting value.

In some embodiments, the fault type determination unit 903 is further configured to: determine a phase with the fault type of the in-region fault as a fault phase, and protect an exit according to the number of the fault phases; and

if the number of the fault phases is less than or equal to a preset number, control a relay protection apparatus to send a fault phase trip instruction to control the fault phase to trip and control a non-fault phase to operate normally; and if the number of the fault phases is greater than the preset number, control the relay protection apparatus to send a three-phase trip instruction to control all of three phases to trip.

The present disclosure provides an electronic device 1000. FIG. 10 is a schematic diagram of a structure of an electronic device 1000 according to an implementation of the present disclosure. Referring to FIG. 10, the electronic device 1000 includes a memory 1001, a processor 1002, and a computer program stored in the memory 1001 and executable on the processor 1002. The processor 1002, when executing the computer program, implements the operations of the above fault identification method as shown in FIG. 1.

The present disclosure provides a computer-readable storage medium having stored thereon a computer program. The computer program, when executed by a processor, implements the operations of the above fault identification method as shown in FIG. 1.

The present disclosure has been described with reference to a few implementations. However, as is well known to those skilled in the art, as limited by the appended claims, embodiments other than those disclosed above by the present disclosure fall equivalently within the scope of the present disclosure.

Generally, all terms used in the claims are explained according to the ordinary meanings in the art, unless otherwise explicitly defined therein. All references to "a/the [apparatus, component, or the like]" are openly explained as at least one example of the apparatus, component, or the like, unless otherwise explicitly illustrated. It is not necessary for the operations of any method disclosed herein to be run in the disclosed exact order, unless explicitly illustrated.

It is to be understood by those skilled in the art that the embodiments of the present disclosure may be provided as methods, systems, or computer program products. Therefore, the present disclosure may adopt the form of a fully hardware embodiment, the form of a fully software embodiment, or the form of combining embodiments in software and hardware aspects. Furthermore, the present disclosure may adopt the form of a computer program product implemented on one or more computer-usable storage media (including a disk memory, a CD-ROM, an optical memory, or the like, but not limited thereto) that contain computer-usable program codes therein.

The present disclosure is described with reference to a flowchart and/or block diagram of a method, a device (system), and a computer program product according to an embodiment of the present disclosure. It should be understood that each process and/or block in the flowchart and/or block diagram, and a combination of processes and/or blocks in the flowchart and/or block diagram may be implemented by computer program instructions. These computer program instructions may be supplied to a processor of a general-purpose computer, a special-purpose computer, an embedded processing machine, or other programmable data processing device to generate a machine, such that instructions executed by the processor of the computer or other programmable data processing device generate apparatuses for implementing the functions specified in one or more processes of the flowchart and/or one or more blocks of the block diagram.

These computer program instructions may also be stored in a computer-readable memory capable of directing a computer or other programmable data processing devices to operate in a specific manner, such that the instructions stored in the computer-readable memory produce a manufactured article including an instruction apparatus that implements the functions specified in one or more processes of the flowchart and/or one or more blocks of the block diagram.

These computer program instructions may also be loaded onto a computer or other programmable data processing devices, so as to perform a series of operations on the computer or other programmable devices to generate computer-implemented processing, so that the instructions executed on the computer or other programmable devices provide operations for implementing the functions specified in one or more processes of the flowchart and/or one or more blocks of the block diagram.

Finally, it should be noted that the above embodiments are merely provided for describing, instead of limiting, the technical solutions of the present disclosure. Although the present disclosure has been described in detail with reference to the embodiments above, those of ordinary skill in the art should understand that any modifications or equivalent replacements made to the specific embodiments without departing from the spirit and scope of the present disclosure shall still fall within the scope of protection of the claims of the present disclosure.

### INDUSTRIAL APPLICABILITY

The present disclosure provides a fault identification method based on full-time-domain abrupt change information, a system, an electronic device, and a computer-readable storage medium. When the high-voltage AC line fails, the current signals on the wind farm side and the flexible DC side are collected, and a respective fault current of each phase on the wind farm side and the flexible DC side are acquired. For each fault current of a respective phase on the wind farm side and the flexible DC side, a respective multi-order matrix is constructed according to the fault current of the phase on the wind farm side and the flexible DC side, and according to the multi-order matrixes, a respective abrupt change characteristic value corresponding to the fault current of the phase on the wind farm side and the flexible DC side is calculated. A respective fault type is determined according to a preset criterion and the abrupt change characteristic value corresponding to the fault current of the phase on the wind farm side and the flexible DC side. According to the method of the present disclosure, the current signals of the phases on both sides of the line are used to construct multi-order matrixes respectively. The characteristic that the multi-order matrix may quickly amplify the proportion of abrupt change signals and the advantage that the matrix gradient may accurately represent the degree of the abrupt change of data are comprehensively used to construct the protection criterion, so as to achieve the high-speed and reliable fault identification, thereby solving the problem of the risk of sensitivity decrease of conventional protection and the risk of incorrect operation in the new power system. The present disclosure may adapt to a scenario of access and delivery of multiple types of new energy power supplies without depending on the power frequency quantity, and have a capacity to withstand the transition resistance and noise and a rapid responsiveness, which has an important engineering significance for the high proportion consumption of the future new energy and the safe operation of the power grid, and provides the premise and guarantee for further development of the new energy power electronic system with a high proportion in the future.

## Claims

1. A fault identification method based on full-time-domain abrupt change information, comprising:
collecting (101), when a high-voltage alternating current, AC, line fails, current signals on a wind farm side and a flexible direct current, DC, side to acquire a respective fault current of each phase on the wind farm side and the flexible DC side;
for each fault current of a respective phase on the wind farm side and the flexible DC side,
constructing (102) a respective multi-order matrix according to the fault current of the phase on the wind farm side and the flexible DC side, and calculating, according to the multi-order matrix, a respective abrupt change characteristic value corresponding to the fault current of the phase on the wind farm side and the flexible DC side; and
determining (103) a respective fault type according to a preset criterion and the abrupt change characteristic value corresponding to the fault current of the phase on the wind farm side and the flexible DC side,
**characterized in that** constructing the respective multi-order matrix according to the fault current of the phase on the wind farm side and the flexible DC side, and calculating, according to the multi-order matrix, the respective abrupt change characteristic value corresponding to the fault current of the phase on the wind farm side and the flexible DC side comprises:
performing operations for the fault current of the phase on the wind farm side and the flexible DC side to acquire the abrupt change characteristic value corresponding to the fault current of the phase on the wind farm side and the flexible DC side, the operations comprising:
determining sample values of a fault current of any phase as a one-dimensional array, and denoting a current signal composed of N sampling points within sampling time as *I* ={*i*₁,*i*₂,*i*₃,···,*i_{N}*}, wherein the multi-order matrix is: ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)} ;$
transforming the multi-order matrix *I_{T}* into expressions of row vectors and column vectors, wherein the expression of the column vectors is *I_{T}* ={*I*₁,*I*₂,*I*₃,···,*I_{N}*}*,* and internal elements of a first column vector are *I*₁ ={*i*₁,*i*₂,*i*₃,···,*i_{N}*}*^{T}; the* expression of the row vectors is *I_{T}* ={*I*₁*^{T}*,*I*₂*^{T}*,*I*₃*^{T}*,···,*I_{N}^{T}*}*^{T},,* and internal elements of a first row vector are *I*₁*^{T}* ={*i*₁,*i*₂,*i*₃,···,*i_{N}*};
calculating a horizontal gradient matrix corresponding to the multi-order matrix with the expression of the column vectors, comprising: $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right] ;$
calculating a vertical gradient matrix corresponding to the multi-order matrix with the expression of the row vectors, comprising: $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T} ;$ and
calculating the abrupt change characteristic value according to the horizontal gradient matrix and the vertical gradient matrix, comprising: $G = {\sum }_{i = 1}^{N} {\sum }_{j = 1}^{N} \left(\left|Gx\left(i, j\right)\right|+\left|Gy\left(i, j\right)\right|\right) ;$
wherein G denotes the respective abrupt change characteristic value corresponding to the fault current of the phase; *Gx* denotes the horizontal gradient matrix, and *Gy* denotes the vertical gradient matrix; *Gx*(*i, j)* denotes an element in an i-th row and a j-th column of the horizontal gradient matrix; and *Gy*(*i, j*) denotes an element in an i-th row and a j-th column of the vertical gradient matrix.

2. The method of claim 1, wherein the fault current of the phase on the wind farm side is: $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right) ;\end{matrix}$ and
the fault current of the phase on the flexible DC side is: ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right) ;$
wherein *i_{wφ}* denotes a fault current of a phase *φ* on the wind farm side; ${i}_{d}^{*}$ denotes a preset current reference value of a d-axis, and ${i}_{q}^{*}$ denotes a preset current reference value of a q-axis; *ω_{PLL}* denotes a fundamental angular frequency; *θ_{φ}* denotes an initial phase angle; *ξ* denotes a damping ratio of a second-order system, *ξ = kᵢₚ* / 2×(*L*×*kᵢᵢ*)^{1/2}; *ω_{d}* denotes a damped natural frequency, *ω_{d}* = *ωₙ* (1*-ξ*²)^{1/2}, *ωₙ* denotes a natural oscillation angular frequency when a damping of the second-order system is zero, *ωₙ* = (*kᵢᵢ* / *L*)^{1/2}; *β* denotes a damping angle of a system, *β* = arctan((1-*ξ*²)^{1/2} / *ξ*); P denotes a single-phase output active power; *u_{d}* denotes a voltage of the d-axis; *i*_{*d*0} denotes an initial current of the d-axis; t denotes fault time; *kᵢₚ* denotes a ratio of a current control loop; *kᵢᵢ* denotes an integral time constant; and L denotes a bridge arm inductance;
wherein *i_{mmcφ}* denotes a fault current of the phase *φ* on the flexible DC side; *E_{f}* denotes an electric potential within a converter; *Z_{eq}* denotes an equivalent impedance; ω denotes an angular frequency of a positive sequence current, and *ω*⁻ denotes an angular frequency of a negative sequence current; m denotes a ratio coefficient related to a short-circuit type; and *θ*_{*φ*-}denotes an initial phase angle of the negative sequence current.

3. The method of claim 1, wherein determining the respective fault type according to the preset criterion and the abrupt change characteristic value corresponding to the fault current of the phase on the wind farm side and the flexible DC side comprising:
for any phase, if fault currents on the wind farm side and the flexible DC side corresponding to the phase meet the preset criterion, determining a fault type of the phase as an in-region fault; and
if the fault currents on the wind farm side and the flexible DC side corresponding to the phase do not meet the preset criterion, determining the fault type of the phase as an out-of-region fault;
wherein the preset criterion comprises ΔG=|*G*₁ *-^{G}*₂| > *Gₛₑₜ, G*₁ denotes the abrupt change characteristic value corresponding to the fault current of the phase on the wind farm side, *G*₂ denotes the abrupt change characteristic value corresponding to the fault current of the phase on the flexible DC side, and *Gₛₑₜ* denotes a preset setting value.

4. The method of claim 1, further comprising:
determining a phase with the fault type of an in-region fault as a fault phase, and protecting an exit according to a number of fault phases; and
if the number of the fault phases is less than or equal to a preset number, controlling a relay protection apparatus to send a fault phase trip instruction to control the fault phase to trip and control a non-fault phase to operate normally; and if the number of the fault phases is greater than the preset number, controlling the relay protection apparatus to send a three-phase trip instruction to control all of three phases to trip.

5. A fault identification system (900) based on full-time-domain abrupt change information, comprising:
a fault current acquisition unit (901), configured to collect, when a high-voltage alternating current, AC, line fails, current signals on a wind farm side and a flexible direct current, DC, side, to acquire a respective fault current of each phase on the wind farm side and the flexible DC side;
an abrupt change characteristic value calculation unit (902), configured to: for each fault current of a respective phase on the wind farm side and the flexible DC side, construct a respective multi-order matrix according to the fault current of the phase on the wind farm side and the flexible DC side, and calculate, according to the multi-order matrix, a respective abrupt change characteristic value corresponding to the fault current of the phase on the wind farm side and the flexible DC side; and
a fault type determination unit (903), configured to determine a respective fault type according to a preset criterion and the abrupt change characteristic value corresponding to the fault current of the phase on the wind farm side and the flexible DC side,
**characterized in that** the abrupt change characteristic value calculation unit is further configured to perform operations for the fault current of the phase on the wind farm side and the flexible DC side to acquire the abrupt change characteristic value corresponding to the fault current of the phase on the wind farm side and the flexible DC side, the operations comprising:
determining sample values of a fault current of any phase as a one-dimensional array, and denoting a current signal composed of N sampling points within sampling time as *I* ={*i*₁,*i*₂,*i*₃,···,*i_{N}*}, wherein the multi-order matrix is: ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)} ;$
transforming the multi-order matrix *I_{T}* into expressions of row vectors and column vectors, wherein the expression of the column vectors is *I_{T}* ={*I*₁,*I*₂,*I*₃,···,*I_{N}*}, and internal elements of a first column vector are *I*₁ ={*i*₁,*i*₂,*i*₃,···,*i_{N}*}*^{T}*; the expression of the row vectors is *I_{T}* ={*I*₁*^{T}*,*I*₂*^{T}*,*I*₃*^{T}*,···,*I_{N}^{T}*}*^{T}*, and internal elements of a first row vector are *I*₁*^{T}* ={*i*₁,*i*₂,*i*₃,···,*i_{N}*};
calculating a horizontal gradient matrix corresponding to the multi-order matrix with the expression of the column vectors, comprising: $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right] ;$
calculating a vertical gradient matrix corresponding to the multi-order matrix with the expression of the row vectors, comprising: $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T} ;$ and
calculating the abrupt change characteristic value according to the horizontal gradient matrix and the vertical gradient matrix, comprising: $G = {\sum }_{i = 1}^{N} {\sum }_{j = 1}^{N} \left(\left|Gx\left(i, j\right)\right|+\left|Gy\left(i, j\right)\right|\right) ;$
wherein G denotes the abrupt change characteristic value corresponding to the fault current of the phase; *Gx* denotes the horizontal gradient matrix, and *Gy* denotes the vertical gradient matrix; *Gx(i, j)* denotes an element in an i-th row and a j-th column of the horizontal gradient matrix; and *Gy(i, j)* denotes an element in an i-th row and a j-th column of the vertical gradient matrix.

6. The system of claim 5, wherein at the fault current acquisition unit, the fault current of the phase on the wind farm side is: $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right) ;\end{matrix}$ and
the fault current of the phase on the flexible DC side is: ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right) ;$
wherein *i_{wφ}* denotes a fault current of a phase *φ* on the wind farm side; ${i}_{d}^{*}$ denotes a preset current reference value of a d-axis, and ${i}_{q}^{*}$ denotes a preset current reference value of a q-axis; *ω_{PLL}* denotes a fundamental angular frequency; *θ_{φ}* denotes an initial phase angle; *ξ* denotes a damping ratio of a second-order system, *ξ = kᵢₚ* / 2×(*L*×*kᵢᵢ*)^{1/2}; *ω_{d}* denotes a damped natural frequency, *ω_{d}* = *ωₙ*(1*-ξ*²)^{1/2}, *ωₙ* denotes a natural oscillation angular frequency when a damping of the second-order system is zero, *ωₙ =* (*kᵢᵢ* / *L*)^{1/2}; *β* denotes a damping angle of a system, *β* = arctan((1-*ξ*²)^{1/2} / *ξ*); P denotes a single-phase output active power; *u_{d}* denotes a voltage of the d-axis; *i*_{*d*0} denotes an initial current of the d-axis; t denotes fault time; *kᵢₚ* denotes a ratio of a current control loop; *kᵢᵢ* denotes an integral time constant; and L denotes a bridge arm inductance;
wherein *i_{mmcφ}* denotes a fault current of the phase *φ* on the flexible DC side; *E_{f}* denotes an electric potential within a converter; *Z_{eq}* denotes an equivalent impedance; ω denotes an angular frequency of a positive sequence current, and *ω⁻* denotes an angular frequency of a negative sequence current; m denotes a ratio coefficient related to a short-circuit type; and *θ_{φ-}* denotes an initial phase angle of the negative sequence current.

7. The system of claim 5, wherein the fault type determination unit is further configured to: for any phase, if fault currents on the wind farm side and the flexible DC side corresponding to the phase meet the preset criterion, determine a fault type of the phase as an in-region fault; and
if the fault currents on the wind farm side and the flexible DC side corresponding to the phase do not meet the preset criterion, determine the fault type of the phase as an out-of-region fault;
wherein the preset criterion comprises Δ*G=*|*G*₁-*G*₂|*>Gₛₑₜ, G*₁ denotes the abrupt change characteristic value corresponding to the fault current of the phase on the wind farm side, *G*₂ denotes the abrupt change characteristic value corresponding to the fault current of the phase on the flexible DC side, and *Gₛₑₜ* denotes a preset setting value.

8. The system of claim 7, wherein the fault type determination unit is further configured to: determine a phase with the fault type of the in-region fault as a fault phase, and protect an exit according to a number of fault phases; and
if the number of the fault phases is less than or equal to a preset number, control a relay protection apparatus to send a fault phase trip instruction to control the fault phase to trip and control a non-fault phase to operate normally; and if the number of the fault phases is greater than the preset number, control the relay protection apparatus to send a three-phase trip instruction to control all of three phases to trip.

9. An electronic device (1000) comprising a memory (1001), a processor (1002), and a computer program stored in the memory (1001) and executable on the processor (1002) that when executing the computer program, implements operations of the method of any one of claims 1-4.

10. A computer-readable storage medium having stored thereon a computer program that when executed by a processor, implements operations of the method of any one of claims 1-4.

## Patentansprüche

1. Fehlererkennungsverfahren basierend auf Vollzeitbereichsinformationen über eine abrupte Änderung, umfassend:
Sammeln (101), wenn eine Hochspannungswechselstromleitung, AC-Leitung, ausfällt, von Stromsignalen auf einer Windparkseite und einer flexiblen Gleichstromseite, DC-Seite, um einen jeweiligen Fehlerstrom jeder Phase auf der Windparkseite und der flexiblen DC-Seite zu erfassen;
für jeden Fehlerstrom einer jeweiligen Phase auf der Windparkseite und der flexiblen Gleichstromseite,
Erstellen (102) einer jeweiligen Matrix mehrfacher Ordnung gemäß dem Fehlerstrom der Phase auf der Windparkseite und der flexiblen DC-Seite, und Berechnen, gemäß der Matrix mehrfacher Ordnung, eines jeweiligen charakteristischen Werts der abrupten Änderung, der dem Fehlerstrom der Phase auf der Windparkseite und der flexiblen DC-Seite entspricht; und
Bestimmen (103) einer jeweiligen Fehlerart gemäß einem voreingestellten Kriterium und dem charakteristischen Wert der abrupten Änderung, der dem Fehlerstrom der Phase auf der Windparkseite und der flexiblen DC-Seite entspricht,
**dadurch gekennzeichnet, dass** das Erstellen der jeweiligen Matrix mehrfacher Ordnung gemäß dem Fehlerstrom der Phase auf der Windparkseite und der flexiblen DC-Seite und das Berechnen, gemäß der Matrix mehrfacher Ordnung, des jeweiligen charakteristischen Werts der abrupten Änderung, der dem Fehlerstrom der Phase auf der Windparkseite und der flexiblen DC-Seite entspricht, umfasst:
Durchführen von Arbeitsabläufen für den Fehlerstrom der Phase auf der Windparkseite und der flexiblen DC-Seite, um den charakteristischen Wert der abrupten Änderung zu erfassen, der dem Fehlerstrom der Phase auf der Windparkseite und der flexiblen DC-Seite entspricht, die Arbeitsabläufe umfassend:
Bestimmen von Abtastwerten eines Fehlerstroms einer beliebigen Phase als ein eindimensionales Array und Bezeichnen eines Stromsignals, das aus N Abtastpunkten innerhalb einer Abtastzeit besteht, als *I* ={*i*₁,*i*₂,*i*₃,···,*i_{N}*}*,* wobei die Matrix mehrfacher Ordnung ist: ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)} ;$
Transformieren der Matrix mehrfacher Ordnung *I_{T}* in Ausdrücke von Zeilenvektoren und Spaltenvektoren, wobei der Ausdruck der Spaltenvektoren *I_{T}* ={*I*₁,*I*₂,*I*₃,···,*I_{N}*} ist und interne Elemente eines ersten Spaltenvektors *I*₁ ={*I*₁*^{T}*,*I*₂*^{T}*,*I*₃*^{T}*,···,*I_{N}^{T}*}*^{T}* sind; der Ausdruck der Zeilenvektoren *I_{T}* ={*I*₁*^{T}*,*I*₂*^{T}*,*I*₃*^{T}*,···,*I_{N}^{T}*}*^{T}* ist und interne Elemente eines ersten Zeilenvektors *I*₁*^{T}* ={*i*₁,*i*₂,*i*₃,···,*i_{N}*} sind;
Berechnen einer horizontalen Gradientenmatrix, die der Matrix mehrfacher Ordnung entspricht, mit dem Ausdruck der Spaltenvektoren, umfassend: $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right] ;$
Berechnen einer vertikalen Gradientenmatrix, die der Matrix mehrfacher Ordnung entspricht, mit dem Ausdruck der Zeilenvektoren, umfassend: $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T} ;$ und
Berechnen des charakteristischen Werts der abrupten Änderung gemäß der horizontalen Gradientenmatrix und der vertikalen Gradientenmatrix, umfassend: $G = {\sum }_{i = 1}^{N} {\sum }_{j = 1}^{N} \left(\left|Gx\left(i, j\right)\right|+\left|Gy\left(i, j\right)\right|\right) ;$
wobei G den jeweiligen charakteristischen Wert der abrupten Änderung bezeichnet, der dem Fehlerstrom der Phase entspricht; *Gx* die horizontale Gradientenmatrix bezeichnet und *Gy* die vertikale Gradientenmatrix bezeichnet; *Gx*(*i, j*) ein Element in einer i-ten Zeile und einer j-ten Spalte der horizontalen Gradientenmatrix bezeichnet; und *Gx*(*i, j*) ein Element in einer i-ten Zeile und einer j-ten Spalte der vertikalen Gradientenmatrix bezeichnet.

2. Verfahren nach Anspruch 1, wobei der Fehlerstrom der Phase auf der Windparkseite ist: $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right) ;\end{matrix}$ und
der Fehlerstrom der Phase auf der flexiblen DC-Seite ist: ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right) ;$
wobei *i_{wφ}* einen Fehlerstrom einer Phase *φ* auf der Windparkseite bezeichnet; ${i}_{d}^{*}$ einen voreingestellten Stromreferenzwert einer d-Achse bezeichnet und ${i}_{q}^{*}$ einen voreingestellten Stromreferenzwert einer q-Achse bezeichnet; *ω_{PLL}* eine Grundkreisfrequenz bezeichnet; *θ_{φ}* einen Anfangsphasenwinkel bezeichnet; *ξ* ein Dämpfungsverhältnis eines Systems zweiter Ordnung, *ξ* = *kᵢₚ* / 2×(*L*×*kᵢᵢ*)^{1/2}*,* bezeichnet; *ω_{d}* eine gedämpfte Eigenfrequenz, *ω_{d}* = *ωₙ*(1-*ξ*²)^{1/2}, bezeichnet, *ωₙ* eine Eigenschwingungskreisfrequenz bezeichnet, wenn eine Dämpfung des Systems zweiter Ordnung null ist, *ωₙ* = (*kᵢᵢ* / *L*)^{1/2}; *β* einen Dämpfungswinkel eines Systems, *β* = arctan((1-*ξ*²)^{1/2} / ζ), bezeichnet; P eine einphasige Ausgangswirkleistung bezeichnet; *u_{d}* eine Spannung der d-Achse bezeichnet; *i*_{*d*0} einen Anfangsstrom der d-Achse bezeichnet; t die Fehlerzeit bezeichnet; *kᵢₚ* ein Verhältnis eines Stromsteuerkreises bezeichnet; *kᵢᵢ* eine Integralzeitkonstante bezeichnet; und L eine Brückenzweiginduktivität bezeichnet;
wobei *i_{mmcφ}* einen Fehlerstrom der Phase *φ* auf der flexiblen DC-Seite bezeichnet; *E_{f}* ein elektrisches Potenzial innerhalb eines Wandlers bezeichnet; *Z_{eq}* eine äquivalente Impedanz bezeichnet; ω eine Kreisfrequenz eines Mitsystemstroms bezeichnet und *ω* eine Kreisfrequenz eines Gegensystemstroms bezeichnet; m einen Verhältniskoeffizienten in Bezug auf eine Kurzschlussart bezeichnet; und *θ*_{*φ*-}einen Anfangsphasenwinkel des Gegensystemstroms bezeichnet.

3. Verfahren nach Anspruch 1, wobei das Bestimmen der jeweiligen Fehlerart gemäß dem voreingestellten Kriterium und dem charakteristischen Wert der abrupten Änderung, der dem Fehlerstrom der Phase auf der Windparkseite und der flexiblen DC-Seite entspricht, umfasst:
für jede Phase, falls Fehlerströme auf der Windparkseite und der flexiblen DC-Seite, die der Phase entsprechen, das voreingestellte Kriterium erfüllen, Bestimmen einer Fehlerart der Phase als einen Fehler in einer Region; und
falls die Fehlerströme auf der Windparkseite und der flexiblen DC-Seite, die der Phase entsprechen, das voreingestellte Kriterium nicht erfüllen, Bestimmen der Fehlerart der Phase als einen Fehler außerhalb der Region;
wobei das voreingestellte Kriterium Δ*G*=|*G*₁ *-G*₂| *> G_{eingestellt}, G*₁ umfasst, *G*₁ den charakteristischen Wert der abrupten Änderung bezeichnet, der dem Fehlerstrom der Phase auf der Windparkseite entspricht, *G*₂ den charakteristischen Wert der abrupten Änderung bezeichnet, der dem Fehlerstrom der Phase auf der flexiblen DC-Seite entspricht, und *G_{eingestellt}* einen voreingestellten Einstellwert bezeichnet.

4. Verfahren nach Anspruch 1, ferner umfassend:
Bestimmen einer Phase mit der Fehlerart eines Fehlers der Region als eine Fehlerphase, und Schützen eines Ausgangs gemäß einer Anzahl von Fehlerphasen; und
falls die Anzahl der Fehlerphasen kleiner als oder gleich einer voreingestellten Anzahl ist, Steuern einer Relaisschutzvorrichtung, um einen Fehlerphasenauslösebefehl zu senden, um die Fehlerphase zu steuern, um ausgelöst zu werden, und eine fehlerfreie Phase zu steuern, um normal zu arbeiten; und, falls die Anzahl der Fehlerphasen größer als die voreingestellte Anzahl ist, Steuern der Relaisschutzvorrichtung, um einen dreiphasigen Ausschaltbefehl zu senden, um alle drei Phasen zu steuern, um ausgelöst zu werden.

5. Fehlererkennungssystem (900) basierend auf Vollzeitbereichsinformationen über die abrupte Änderung, umfassend:
eine Fehlerstromerfassungseinheit (901), die konfiguriert ist, um, wenn eine Hochspannungswechselstromleitung, AC-Leitung, ausfällt, Stromsignale auf einer Windparkseite und einer flexiblen Gleichstromseite, DC-Seite, zu sammeln, um einen jeweiligen Fehlerstrom jeder Phase auf der Windparkseite und der flexiblen DC-Seite zu erfassen;
eine Berechnungseinheit (902) für den charakteristischen Wert der abrupten Änderung, die konfiguriert ist zum: für jeden Fehlerstrom einer jeweiligen Phase auf der Windparkseite und der flexiblen DC-Seite, Erstellen einer jeweiligen Matrix mehrfacher Ordnung gemäß dem Fehlerstrom der Phase auf der Windparkseite und der flexiblen Gleichstromseite, und Berechnen, gemäß der Matrix mehrfacher Ordnung, eines jeweiligen charakteristischen Werts der abrupten Änderung, der dem Fehlerstrom der Phase auf der Windparkseite und der flexiblen Gleichstromseite entspricht; und
eine Fehlerartbestimmungseinheit (903), die konfiguriert ist, um eine jeweilige Fehlerart gemäß einem voreingestellten Kriterium und dem charakteristischen Wert der abrupten Änderung zu bestimmen, der dem Fehlerstrom der Phase auf der Windparkseite und der flexiblen Gleichstromseite entspricht,
**dadurch gekennzeichnet, dass** die Berechnungseinheit für den charakteristischen Wert der abrupten Änderung ferner konfiguriert ist, um Arbeitsabläufe für den Fehlerstrom der Phase auf der Windparkseite und der flexiblen Gleichstromseite durchzuführen, um den charakteristischen Wert der abrupten Änderung zu erfassen, der dem Fehlerstrom der Phase auf der Windparkseite und der flexiblen Gleichstromseite entspricht, die Arbeitsabläufe umfassend:
Bestimmen von Abtastwerten eines Fehlerstroms einer beliebigen Phase als ein eindimensionales Array und Bezeichnen eines Stromsignals, das aus N Abtastpunkten innerhalb einer Abtastzeit besteht, als *I* ={*i*₁,*i*₂,*i*₃,···,*i_{N}*}, wobei die Matrix mehrfacher Ordnung ist: ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)} ;$
Transformieren der Matrix mehrfacher Ordnung *I_{T}* in Ausdrücke von Zeilenvektoren und Spaltenvektoren, wobei der Ausdruck der Spaltenvektoren *I_{T}* ={*I*₁,*I*₂,*I*₃,···,*I_{N}*} ist und interne Elemente eines ersten Spaltenvektors *I*₁ ={*i*₁,*i*₂,*i*₃,···*,*}*^{T}* sind; der Ausdruck der Zeilenvektoren *I_{T}* ={*I*₁*^{T}*,*I*₂*^{T}*,*I*₃*^{T}*,···,*I_{N}^{T}*}*^{T}* ist und interne Elemente eines ersten Zeilenvektors *I_{T}* ={*i*₁,*i*₂,*i*₃,···,*i_{N}*} sind;
Berechnen einer horizontalen Gradientenmatrix, die der Matrix mehrfacher Ordnung entspricht, mit dem Ausdruck der Spaltenvektoren, umfassend: $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right] ;$
Berechnen einer vertikalen Gradientenmatrix, die der Matrix mehrfacher Ordnung entspricht, mit dem Ausdruck der Zeilenvektoren, umfassend: $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T} ;$
und
Berechnen des charakteristischen Werts der abrupten Änderung gemäß der horizontalen Gradientenmatrix und der vertikalen Gradientenmatrix, umfassend: $G = {\sum }_{i = 1}^{N} {\sum }_{j = 1}^{N} \left(\left|Gx\left(i, j\right)\right|+\left|Gy\left(i, j\right)\right|\right) ;$
wobei G den charakteristischen Wert der abrupten Änderung bezeichnet, der dem Fehlerstrom der Phase entspricht; *Gx* die horizontale Gradientenmatrix bezeichnet und *Gy* die vertikale Gradientenmatrix bezeichnet; *Gx*(*i, j*) ein Element in einer i-ten Zeile und einer j-ten Spalte der horizontalen Gradientenmatrix bezeichnet; und *Gx*(*i, j*) ein Element in einer i-ten Zeile und einer j-ten Spalte der vertikalen Gradientenmatrix bezeichnet.

6. System nach Anspruch 5, wobei an der Fehlerstromerfassungseinheit der Fehlerstrom der Phase auf der Windparkseite ist: $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right) ;\end{matrix}$ und
der Fehlerstrom der Phase auf der flexiblen DC-Seite ist: ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right) ;$
wobei *i_{wφ}* einen Fehlerstrom einer Phase *φ* auf der Windparkseite bezeichnet; ${i}_{d}^{*}$ einen voreingestellten Stromreferenzwert einer d-Achse bezeichnet und ${i}_{q}^{*}$ einen voreingestellten Stromreferenzwert einer q-Achse bezeichnet; *ω_{PLL}* eine Grundkreisfrequenz bezeichnet; *θ*_{φ} einen Anfangsphasenwinkel bezeichnet; *ξ* ein Dämpfungsverhältnis eines Systems zweiter Ordnung, *ξ*= *kᵢₚ* / 2 × (*L* × *kᵢᵢ*)^{1/2} bezeichnet; *ω_{d}* eine gedämpfte Eigenfrequenz, *ω_{d} = ωₙ*(1-*ξ*²)^{1/2} bezeichnet, *ωₙ* eine Eigenschwingungskreisfrequenz bezeichnet, wenn eine Dämpfung des Systems zweiter Ordnung null ist, *ωₙ*=(*kᵢᵢ* / *L*)^{1/2}; *β* einen Dämpfungswinkel eines Systems, *β = arctan*((1-*ξ*²)^{1/2} / *ξ*) bezeichnet; P eine einphasige Ausgangswirkleistung bezeichnet; *u_{d}* eine Spannung der d-Achse bezeichnet; *i*_{*d*0} einen Anfangsstrom der d-Achse bezeichnet; t die Fehlerzeit bezeichnet; *kᵢₚ* ein Verhältnis eines Stromsteuerkreises bezeichnet; *kᵢᵢ* eine Integralzeitkonstante bezeichnet; und L eine Brückenzweiginduktivität bezeichnet;
wobei *i_{mmcφ}* einen Fehlerstrom der Phase *φ* auf der flexiblen DC-Seite bezeichnet; *E_{f}* ein elektrisches Potenzial innerhalb eines Wandlers bezeichnet; *Z_{eq}* eine äquivalente Impedanz bezeichnet; ω eine Kreisfrequenz eines Mitsystemstroms bezeichnet und *ω⁻* eine Kreisfrequenz eines Gegensystemstroms bezeichnet; m einen Verhältniskoeffizienten in Bezug auf eine Kurzschlussart bezeichnet; und *θ*_{*φ*-}einen Anfangsphasenwinkel des Gegensystemstroms bezeichnet.

7. System nach Anspruch 5, wobei die Fehlerartbestimmungseinheit ferner konfiguriert ist zum: für eine beliebige Phase, falls Fehlerströme auf der Windparkseite und der flexiblen Gleichstromseite, die der Phase entsprechen, das voreingestellte Kriterium erfüllen, Bestimmen einer Fehlerart der Phase als einen Fehler in der Region; und
falls die Fehlerströme auf der Windparkseite und der flexiblen DC-Seite, die der Phase entsprechen, das voreingestellte Kriterium nicht erfüllen, Bestimmen der Fehlerart der Phase als einen Fehler außerhalb der Region;
wobei das voreingestellte Kriterium Δ*G*=|*G*₁*-G*₂|>*G_{eingestelll}, G*₁ umfasst, *G*₁ den charakteristischen Wert der abrupten Änderung bezeichnet, der dem Fehlerstrom der Phase auf der Windparkseite entspricht, *G*₂ den charakteristischen Wert der abrupten Änderung bezeichnet, der dem Fehlerstrom der Phase auf der flexiblen DC-Seite entspricht, und *G_{eingestellt}* einen voreingestellten Einstellwert bezeichnet.

8. System nach Anspruch 7, wobei die Fehlerartbestimmungseinheit ferner konfiguriert ist zum: Bestimmen einer Phase mit der Fehlerart des Fehlers in der Region als eine Fehlerphase, und Schützen eines Ausgangs gemäß einer Anzahl von Fehlerphasen; und
falls die Anzahl der Fehlerphasen kleiner als oder gleich einer voreingestellten Anzahl ist, Steuern einer Relaisschutzvorrichtung, um einen Fehlerphasenauslösebefehl zu senden, um die Fehlerphase zu steuern, um ausgelöst zu werden, und eine fehlerfreie Phase zu steuern, um normal zu arbeiten; und falls die Anzahl der Fehlerphasen größer als die voreingestellte Anzahl ist, die Relaisschutzvorrichtung zu steuern, um einen dreiphasigen Ausschaltbefehl zu senden, um alle drei Phasen zu steuern, um ausgelöst zu werden.

9. Elektronische Einrichtung (1000), umfassend einen Speicher (1001), einen Prozessor (1002) und ein Computerprogramm, das in dem Speicher (1001) gespeichert und auf dem Prozessor (1002) ausführbar ist, der, wenn das Computerprogramm ausgeführt wird, Arbeitsabläufe des Verfahrens nach einem der Ansprüche 1 bis 4 implementiert.

10. Computerlesbares Speichermedium, das ein Computerprogramm darauf gespeichert aufweist, das, wenn es durch einen Prozessor ausgeführt wird, Abläufe nach einem der Ansprüche 1 bis 4 implementiert.

## Revendications

1. Procédé d'identification de défaut basé sur des informations de variation brusque dans l'ensemble du domaine temporel, comprenant :
la collecte (101), lorsqu'une ligne à courant alternatif, CA, à haute tension est défaillante, de signaux de courant sur un côté parc éolien et un côté courant continu, CC, flexible pour acquérir un courant de défaut respectif de chaque phase côté parc éolien et côté CC flexible ;
pour chaque courant de défaut d'une phase respective côté parc éolien et côté CC flexible,
la construction (102) d'une matrice multi-ordre respective en fonction du courant de défaut de la phase côté parc éolien et côté CC flexible, et le calcul, selon la matrice multi-ordre, d'une valeur caractéristique de variation brusque respective correspondant au courant de défaut de la phase côté parc éolien et côté CC flexible ; et
la détermination (103) d'un type de défaut respectif selon un critère prédéfini et la valeur caractéristique de variation brusque correspondant au courant de défaut de la phase du côté parc éolien et du côté CC flexible,
**caractérisé en ce que** la construction de la matrice multi-ordre respective en fonction du courant de défaut de la phase côté parc éolien et côté CC flexible, et le calcul, selon la matrice multi-ordre, de la valeur caractéristique de variation brusque respective correspondant au courant de défaut de la phase côté parc éolien et côté CC flexible comprennent :
le fait d'effectuer des opérations pour le courant de défaut de la phase côté parc éolien et côté CC flexible pour acquérir la valeur caractéristique de variation brusque correspondant au courant de défaut de la phase côté parc éolien et côté CC flexible, les opérations comprenant :
la détermination de valeurs d'échantillon d'un courant de défaut d'une phase quelconque sous la forme d'un tableau unidimensionnel, et la désignation d'un signal de courant composé de N points d'échantillonnage dans un temps d'échantillonnage par *I* ={*i*₁,*i*₂*,i*₃*,*···,*,i_{N}*}, dans lequel la matrice multi-ordre est : ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)} ;$
la transformation de la matrice multi-ordre *I_{T}* en expressions de vecteurs lignes et de vecteurs colonnes, dans lequel l'expression des vecteurs colonnes est *I_{T}* ={*I*₁,*I*₂,*I*₃,···,*I_{N}*}, et des éléments internes d'un premier vecteur colonne sont *I*₁ ={*i*₁,*i*₂,*i*₃,···,*i_{N}*}*^{T}*; l'expression des vecteurs lignes est *I_{T}* ={*I*₁*^{T}*,*I*₂*^{T}*,*I*₃*^{T}*,···,*I_{N}^{T}*}*^{T}*, et des éléments internes d'un premier vecteur ligne sont *I*₁*^{T}* ={*i*₁,*i*₂,*i*₃,···,*i_{N}*} ;
le calcul d'une matrice de gradient horizontal correspondant à la matrice multi-ordre avec l'expression des vecteurs colonnes, comprenant : $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right] ;$
le calcul d'une matrice de gradient vertical correspondant à la matrice multi-ordre avec l'expression des vecteurs lignes, comprenant : $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T} ;$ et
le calcul de la valeur caractéristique de variation brusque selon la matrice de gradient horizontal et la matrice de gradient vertical, comprenant : $G = {\sum }_{i = 1}^{N} {\sum }_{j = 1}^{N} \left(\left|Gx\left(i, j\right)\right|+\left|Gy\left(i, j\right)\right|\right) ;$
où G désigne la valeur caractéristique de variation brusque respective correspondant au courant de défaut de la phase ; *Gx* désigne la matrice de gradient horizontal, et *Gy* désigne la matrice de gradient vertical ; *Gx*(*i, j*) désigne un élément dans une i-ème ligne et une j-ème colonne de la matrice de gradient horizontal ; et *Gy*(*i,* j) désigne un élément dans une i-ème ligne et une j-ème colonne de la matrice de gradient vertical.

2. Procédé selon la revendication 1, dans lequel le courant de défaut de la phase côté parc éolien est : $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right) ;\end{matrix}$ et
le courant de défaut de la phase côté CC flexible est : ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right) ;$
où *i_{wφ}* désigne un courant de défaut d'une phase *φ* côté parc éolien ; ${i}_{d}^{*}$ désigne une valeur de référence de courant prédéfinie d'un axe d, et ${i}_{q}^{*}$ désigne une valeur de référence de courant prédéfinie d'un axe q ; *ω_{PLL}* désigne une fréquence angulaire fondamentale ; *θ_{φ}* désigne un angle de phase initial ; *ξ* désigne un rapport d'amortissement d'un système du second ordre, *ξ* = *kᵢₚ* / 2 × (*L* × *kᵢᵢ*)^{1/2}; *ω_{d}* désigne une fréquence propre amortie, *ω_{d}* = *ωₙ*(1*-ξ*²)^{1/2}, *ωₙ* désigne une fréquence angulaire d'oscillation propre lorsqu'un amortissement du système du second ordre est nul, *ωₙ* = (*kᵢᵢ* / *L*)^{1/2}; *β* désigne un angle d'amortissement d'un système, *β* = arctan((1-*ξ*²)^{1/2} / *ξ*); P désigne une puissance active de sortie monophasée ; *u_{d}* désigne une tension de l'axe d ; *i*_{*d*0} désigne un courant initial de l'axe d ; t désigne le temps de défaut ; *kᵢₚ* désigne un rapport d'une boucle de commande de courant ; *kᵢᵢ* désigne une constante de temps d'intégration ; et L désigne une inductance de branche de pont ;
où *i_{mmcφ}* désigne un courant de défaut de la phase *φ* côté CC flexible ; *E_{f}* désigne un potentiel électrique dans un convertisseur ; *Z_{eq}* désigne une impédance équivalente ; ω désigne une fréquence angulaire d'un courant de séquence directe, et *ω⁻* désigne une fréquence angulaire d'un courant de séquence inverse ; m désigne un coefficient de rapport lié à un type de courtcircuit ; et *θ_{φ-}* désigne un angle de phase initial du courant de séquence inverse.

3. Procédé selon la revendication 1, dans lequel la détermination du type de défaut respectif selon le critère prédéfini et la valeur caractéristique de variation brusque correspondant au courant de défaut de la phase côté parc éolien et côté CC flexible comprend :
pour n'importe quelle phase, si des courants de défaut côté parc éolien et côté CC flexible correspondant à la phase satisfont au critère prédéfini, la détermination d'un type de défaut de la phase en tant que défaut dans la région ; et
si les courants de défaut côté parc éolien et côté CC flexible correspondant à la phase ne satisfont pas au critère prédéfini, la détermination du type de défaut de la phase en tant que défaut hors région ;
dans lequel le critère prédéfini comprend *ΔG=*|*G*₁*-G*₂|*>Gₛₑₜ, G*₁ désigne la valeur caractéristique de variation brusque correspondant au courant de défaut de la phase côté parc éolien, *G*₂ désigne la valeur caractéristique de variation brusque correspondant au courant de défaut de la phase côté CC flexible, et *Gₛₑₜ* désigne une valeur de réglage prédéfinie.

4. Procédé selon la revendication 1, comprenant en outre :
la détermination d'une phase avec le type de défaut d'un défaut dans la région en tant que phase en défaut, et le fait de protéger une sortie en fonction d'un nombre de phases en défaut ; et
si le nombre des phases en défaut est inférieur ou égal à un nombre prédéfini, la commande d'un appareil de protection à relais pour envoyer une instruction de déclenchement de phase en défaut pour commander la phase en défaut pour qu'elle se déclenche et commander une phase non en défaut pour qu'elle fonctionnement normalement ; et si le nombre des phases en défaut est supérieur au nombre prédéfini, la commande de l'appareil de protection à relais pour envoyer une instruction de déclenchement triphasé pour commander l'ensemble des trois phases pour qu'elles se déclenchent.

5. Système d'identification de défaut (900) basé sur des informations de variation brusque dans l'ensemble du domaine temporel, comprenant :
une unité d'acquisition de courant de défaut (901), configurée pour collecter, lorsqu'une ligne à courant alternatif, CA, à haute tension est défaillante, des signaux de courant sur un côté parc éolien et un côté courant continu, CC, flexible, pour acquérir un courant de défaut respectif de chaque phase côté parc éolien et côté CC flexible ;
une unité de calcul de valeur caractéristique de variation brusque (902), configurée pour : pour chaque courant de défaut d'une phase respective côté parc éolien et côté CC flexible, construire une matrice multi-ordre respective en fonction du courant de défaut de la phase côté parc éolien et côté CC flexible, et calculer, selon la matrice multi-ordre, une valeur caractéristique de variation brusque respective correspondant au courant de défaut de la phase côté parc éolien et côté CC flexible ; et
une unité de détermination de type de défaut (903), configurée pour déterminer un type de défaut respectif selon un critère prédéfini et la valeur caractéristique de variation brusque correspondant au courant de défaut de la phase côté parc éolien et côté CC flexible,
**caractérisé en ce que** l'unité de calcul de valeur caractéristique de variation brusque est en outre configurée pour effectuer des opérations pour le courant de défaut de la phase côté parc éolien et côté CC flexible pour acquérir la valeur caractéristique de variation brusque correspondant au courant de défaut de la phase côté parc éolien et côté CC flexible, les opérations comprenant :
la détermination de valeurs d'échantillon d'un courant de défaut d'une phase quelconque sous la forme d'un tableau unidimensionnel, et la désignation d'un signal de courant composé de N points d'échantillonnage dans un temps d'échantillonnage par *I* ={*i*₁,*i*₂*,i*₃*,*···, *i_{N}*}, dans lequel la matrice multi-ordre est : ${I}_{T} = {\left[\begin{matrix}{i}_{1} & {i}_{2} & {i}_{3} & … & {i}_{N} \\ {i}_{2} & {i}_{1} & {i}_{2} & … & {i}_{N - 1} \\ {i}_{3} & {i}_{2} & {i}_{1} & … & {i}_{N - 2} \\ : & : & : & : & : \\ {i}_{N} & {i}_{N - 1} & {i}_{N - 2} & … & {i}_{1}\end{matrix}\right]}_{\left(N\times N\right)} ;$
la transformation de la matrice multi-ordre *I_{T}* en expressions de vecteurs lignes et de vecteurs colonnes, dans lequel l'expression des vecteurs colonnes est *I_{T}* ={*I*₁,*I*₂,*I*₃,···,*I_{N}*}, et des éléments internes d'un premier vecteur colonne sont *I*₁ ={*i*₁,*i*₂,*i*₃,···,*i_{N}*}*^{T}*; l'expression des vecteurs lignes est *I_{T}* ={*I*₁*^{T}*,*I*₂*^{T}*,*I*₃*^{T}*,···,*I_{N}^{T}*}*^{T}*, et des éléments internes d'un premier vecteur ligne sont *I*₁*^{T}* ={*i*₁,*i*₂,*i*₃,···,*I_{N}*};
le calcul d'une matrice de gradient horizontal correspondant à la matrice multi-ordre avec l'expression des vecteurs colonnes, comprenant : $Gx = \left[\frac{{I}_{1} - {I}_{2}}{1} \frac{\left({I}_{1}-{I}_{2}\right) + \left({I}_{3}-{I}_{2}\right)}{2} \frac{\left({I}_{2}-{I}_{3}\right) + \left({I}_{4}-{I}_{3}\right)}{2} \frac{\left({I}_{3}-{I}_{4}\right) + \left({I}_{5}-{I}_{4}\right)}{2} … \frac{{I}_{N} - {I}_{N - 1}}{1}\right] ;$
le calcul d'une matrice de gradient vertical correspondant à la matrice multi-ordre avec l'expression des vecteurs lignes, comprenant : $G y = {\left[\frac{{I}_{1}^{T} - {I}_{2}^{T}}{1} \frac{\left({I}_{1}^{T}-{I}_{2}^{T}\right) + \left({I}_{3}^{T}-{I}_{2}^{T}\right)}{2} \frac{\left({I}_{2}^{T}-{I}_{3}^{T}\right) + \left({I}_{4}^{T}-{I}_{3}^{T}\right)}{2} \frac{\left({I}_{3}^{T}-{I}_{4}^{T}\right) + \left({I}_{5}^{T}-{I}_{4}^{T}\right)}{2}… \frac{{I}_{N}^{T} - {I}_{N - 1}^{T}}{1}\right]}^{T} ;$ et
le calcul de la valeur caractéristique de variation brusque selon la matrice de gradient horizontal et la matrice de gradient vertical, comprenant : $G = {\sum }_{i = 1}^{N} {\sum }_{j = 1}^{N} \left(\left|Gx\left(i, j\right)\right|+\left|Gy\left(i, j\right)\right|\right) ;$
où G désigne la valeur caractéristique de variation brusque correspondant au courant de défaut de la phase ; *Gx* désigne la matrice de gradient horizontal, et *Gy* désigne la matrice de gradient vertical ; *Gx*(*i, j*) désigne un élément dans une i-ème ligne et une j-ème colonne de la matrice de gradient horizontal ; et *Gy*(*i, j*) désigne un élément dans une i-ème ligne et une j-ème colonne de la matrice de gradient vertical.

6. Système selon la revendication 5, dans lequel, au niveau de l'unité d'acquisition de courant de défaut, le courant de défaut de la phase côté parc éolien est : $\begin{matrix}{i}_{wφ} = \frac{2 P}{3 {u}_{d}} cos \left({ω}_{PLL}t+{θ}_{φ}\right) - {i}_{q}^{*} sin \left({ω}_{PLL}t+{θ}_{φ}\right) + \\ \left({i}_{d 0}-\frac{2 P}{3 {u}_{d}}\right) \frac{1}{\sqrt{1 - {ξ}^{2}}} {e}^{- {ξω}_{n} t} ⋅ sin \left({ω}_{d}t+β\right) ⋅ cos \left({ω}_{PLL}t+{θ}_{φ}\right) + \\ {i}_{q}^{*} \frac{2 \sqrt{{Lk}_{ii}}}{\sqrt{4 {k}_{ii} L - {k}_{ip}^{2}}} {e}^{- \left({k}_{ip}/2L\right) t} ⋅ sin \left(\frac{\sqrt{4 {k}_{ii} L - {k}_{ip}^{2}}}{2 L}t+β\right) ⋅ sin \left({ω}_{PLL}t+{θ}_{φ}\right) ;\end{matrix}$ et
le courant de défaut de la phase côté CC flexible est : ${i}_{mmcφ} = \frac{{E}_{f} cos \left(ωt+{θ}_{φ}\right)}{{Z}_{eq}} + m \left(\frac{{E}_{f}}{{Z}_{eq}}+\left|{i}_{wφ}\right|\right) cos \left({ω}^{-}t+{θ}_{φ -}\right) ;$
où *i_{wφ}* désigne un courant de défaut d'une phase *φ* côté parc éolien ; ${i}_{d}^{*}$ désigne une valeur de référence de courant prédéfinie d'un axe d, et ${i}_{q}^{*}$ désigne une valeur de référence de courant prédéfinie d'un axe q ; *ω_{PLL}* désigne une fréquence angulaire fondamentale ; *θ_{φ}* désigne un angle de phase initial ; *ξ* désigne un rapport d'amortissement d'un système du second ordre, *ξ = kᵢₚ* / 2 × (*L* × *kᵢᵢ*)^{1/2}; *ω_{d}* désigne une fréquence propre amortie, *ω_{d} = ωₙ*(1-*ξ²*)^{1/2}, *ωₙ* désigne une fréquence angulaire d'oscillation propre lorsqu'un amortissement du système du second ordre est nul, *ωₙ =*(*kᵢᵢ* / *L*)^{1/2}; *β* désigne un angle d'amortissement d'un système, *β*= arctan((1-*ξ*²)^{1/2} / *ξ*); P désigne une puissance active de sortie monophasée ; *u_{d}* désigne une tension de l'axe d ; *i*_{*d*0} désigne un courant initial de l'axe d ; t désigne le temps de défaut ; *kᵢₚ* désigne un rapport d'une boucle de commande de courant ; *kᵢᵢ* désigne une constante de temps d'intégration ; et L désigne une inductance de branche de pont ;
où *i_{mmcφ}* désigne un courant de défaut de la phase *φ* côté CC flexible ; *E_{f}* désigne un potentiel électrique dans un convertisseur ; *Z_{eq}* désigne une impédance équivalente ; ω désigne une fréquence angulaire d'un courant de séquence directe, et *ω* désigne une fréquence angulaire d'un courant de séquence inverse ; m désigne un coefficient de rapport lié à un type de courtcircuit ; et *θ_{φ-}* désigne un angle de phase initial du courant de séquence inverse.

7. Système selon la revendication 5, dans lequel l'unité de détermination de type de défaut est en outre configurée pour : pour n'importe quelle phase, si des courants de défaut côté parc éolien et côté CC flexible correspondant à la phase satisfont au critère prédéfini, déterminer un type de défaut de la phase en tant que défaut dans la région ; et
si les courants de défaut côté parc éolien et côté CC flexible correspondant à la phase ne satisfont pas au critère prédéfini, déterminer le type de défaut de la phase en tant que défaut hors région ;
dans lequel le critère prédéfini comprend Δ*G=* |*G*₁ *- G*₂| *> Gₛₑₜ, G*₁ désigne la valeur caractéristique de variation brusque correspondant au courant de défaut de la phase côté parc éolien, *G*₂ désigne la valeur caractéristique de variation brusque correspondant au courant de défaut de la phase côté CC flexible, et *Gₛₑₜ* désigne une valeur de réglage prédéfinie.

8. Système selon la revendication 7, dans lequel l'unité de détermination de type de défaut est en outre configurée pour : déterminer une phase avec le type de défaut du défaut dans la région en tant que phase de défaut, et protéger une sortie en fonction d'un nombre de phases en défaut ; et
si le nombre des phases en défaut est inférieur ou égal à un nombre prédéfini, commander un appareil de protection à relais pour envoyer une instruction de déclenchement de phase en défaut pour commander la phase en défaut pour qu'elle se déclenche et commander une phase non en défaut pour qu'elle fonctionnement normalement ; et si le nombre des phases en défaut est supérieur au nombre prédéfini, commander l'appareil de protection à relais pour envoyer une instruction de déclenchement triphasé pour commander l'ensemble des trois phases pour qu'elles se déclenchent.

9. Dispositif électronique (1000) comprenant une mémoire (1001), un processeur (1002), et un programme informatique stocké dans la mémoire (1001) et exécutable sur le processeur (1002), lequel, lorsqu'il exécute le programme informatique, met en œuvre des opérations du procédé selon l'une quelconque des revendications 1 à 4.

10. Support de stockage lisible par ordinateur sur lequel est stocké un programme informatique qui, lorsqu'il est exécuté par un processeur, met en œuvre des opérations du procédé selon l'une quelconque des revendications 1 à 4.
